# EUROPEAN PATENT APPLICATION

(11) **EP 4 156 250 A1**
(43) Date of publication of application: **29.03.2023**
(21) Application number: 22184086.1
(22) Date of filing: 11.07.2022
(51) Int. Cl.: H01L 23/427, H01L 23/473, H01L 25/065

(54) **A SYSTEM FOR HEATSPREADING COMPRISING MICROCHANNELS**

(30) Priority: 23.09.2021 US 202117482926
(71) Applicant: INTEL Corporation, Santa Clara, CA 95054 (US)
(72) Inventor: RAHMAN, MOHAMMAD MAMUNAR, Gilbert, 85298 (US); ECTON, JEREMY D., Gilbert, 85298 (US); CHANG, JE-YOUNG, Tempe, 85283 (US)
(74) Representative: Goddar, Heinz J.

(57) **Abstract**

A system includes a package layer with microchannels to spread heat localized in the package at an electronic die. The microchannel is integrated onto or into the package layer. The microchannel has a hollow heat conducting material with a rectangular cross-section through which a fluid is to flow to spread the heat. The microchannel can be an open channel that is sealed with a pump to cause the fluid to flow through the microchannel. The microchannel can be sealed in the integration process to result in a closed heat pipe structure in which liquid flows through expansion and compression in response to heating and cooling, respectively.

## Description

### FIELD

Descriptions are generally related to computer systems, and more particular descriptions are related to heat transfer in a computer system.

### BACKGROUND

Multicore processors (MCPs) are non-uniform in heat generation. MCPs create areas of high local heat at a few locations on the die or passive components in the substrate (e.g., inductors), which are known as "hot spots". The need for more efficient heat removal from the hot spots increases with stacked-die device architectures, including 3D (three-dimensional) through-silicon-via (TSV) assemblies, which are more difficult to cool. While the top die in a 3D stack may be placed in intimate thermal contact with a heat spreader, heat sink, or heat pipe, the interposed die (i.e., the die sandwiched between the substrate and the top die) does not have a low resistance thermal path to dissipate heat.

Poor heat rejection from the interposed die places severe design constraints on 3D TSV stacked-die architectures, as there is an effective limitation to place a high-power die on top of the stack. Stated more generally, as packages become more complex with active dies embedded in the package, heat generation increases beyond the ability of traditional heat dissipation resources to remove.

### BRIEF DESCRIPTION OF THE DRAWINGS

The following description includes discussion of figures having illustrations given by way of example of an implementation. The drawings should be understood by way of example, and not by way of limitation. As used herein, references to one or more examples are to be understood as describing a particular feature, structure, or characteristic included in at least one implementation of the invention. Phrases such as "in one example" or "in an alternative example" appearing herein provide examples of implementations of the invention, and do not necessarily all refer to the same implementation. However, they are also not necessarily mutually exclusive.
**Figure 1A** is a block diagram of an example of a system with microchannels in a substrate.
**Figure 1B** is a block diagram of an example of a system with microchannels in an integrated heat spreader.
**Figure 1C** is a block diagram of an example of a system with microchannels in a substrate and microchannels in an integrated heat spreader.
**Figure 1D** is a block diagram of an example of a system with microchannels in a substrate of a multi-die stack.
**Figure 1E** is a block diagram of an example of a system with microchannels in an interposer board of a multi-die stack.
**Figures 2A-2K** represent stages in the creation of an integrated circuit with open microchannels with a rectangular cross-section.
**Figure 3** is a flow diagram of an example of a process for creating an integrated circuit with open microchannels with a rectangular cross-section.
**Figures 4A-4R** represent stages in the creation of an integrated circuit with closed microchannels with a rectangular cross-section.
**Figure 5** is a flow diagram of an example of a process for creating an integrated circuit with closed microchannels with a rectangular cross-section.
**Figures 6A-6R** represent stages in the creation of an integrated circuit with closed microchannels with a triangular cross-section.
**Figure 7** is a flow diagram of an example of a process for creating an integrated circuit with closed microchannels with a triangular cross-section.
**Figure 8A** is a block diagram of an example of a system with straight microchannels to spread heat from a hot spot.
**Figure 8B** is a block diagram of an example of a system with microchannels having a serpentine pattern to spread heat from a hot spot.
**Figure 8C** is a block diagram of an example of a system with another microchannel pattern to spread heat from a hot spot.
**Figure 8D** is a block diagram of an example of a system with another microchannel pattern to spread heat from a hot spot.
**Figure 8E** is a block diagram of an example of a system with closed loop microchannel patterns to spread heat from a hot spot.
**Figure** 9 is a block diagram of an example of a system with a pump for a substrate with open microchannels.
**Figure 10** is a block diagram of an example of a computing system in which an integrated microchannel heat spreader can be implemented.
**Figure 11** is a block diagram of an example of a mobile device in which an integrated microchannel heat spreader can be implemented.
**Figure 12** is a block diagram of an example of a multi-node network in which an integrated microchannel heat spreader can be implemented.

Descriptions of certain details and implementations follow, including non-limiting descriptions of the figures, which may depict some or all examples, and well as other potential implementations.

### DETAILED DESCRIPTION

As described herein, a system includes a package layer with microchannels to spread heat localized in the package at an electronic die. The microchannel is integrated onto or into the package layer. The microchannel has a hollow heat conducting material through which a fluid is to flow to spread the heat. The microchannel can have a rectangular cross-section. The microchannel can have a triangular cross-section or a trapezoidal cross-section. The microchannel can be an open channel that is sealed with a pump to cause the fluid to flow through the microchannel. The microchannel can be sealed in the integration process to result in a closed heat pipe structure in which liquid flows through expansion and compression in response to heating and cooling, respectively. In a heat pipe, the liquid can diffuse through the microchannel based on capillary action.

To optimize performance of 3D stacked die complex products, flexibility to have microchannels or heat pipes embedded in a layer of the electronic device package can provide an intimate thermal path to dissipate heat away from a localized hot spot. Alleviation of localized hot spots improve cooling of a high power or high-performance die, which can improve the performance of the device. An integrated microchannel generally refers to an integrated hollow structure through a package layer, such as a substrate, an integrated heat spreader (IHS), an interposer layer, or other layer. The integrated microchannel can be multiple centimeters in length. The integrated microchannel can be referred to as a heat pipe when sealed. For purposes of description herein, any such structure can be referred to as a microchannel. Reference to a heat pipe or micro heat pipe (MHP) is to a microchannel that is sealed during the circuit processing.

Embedding microchannels in the package or IHS enable the microchannel to redistribute the heat quickly and efficiently from hot spots. When implemented as an MHP, it will be understood that the heat distribution system is a closed loop system, which has no need to re-charge working fluid. Thus, MHP implementations are applicable for devices ranging from small chips for thin and light handhelds to very large chips for servers. Since the microchannels allow more heat to be transferred, they can provide improved performance in larger devices, such as server processors.

In one example, the microchannel is not closed during the processing of the structure. The microchannel can be sealed with a pump to allow a pump component to pump fluid through the microchannel structure. The fluid used in the microchannel or MHP can depend on the operating temperature of the system or the die and the chemistry of the metal or heat conducting material used to form the microchannel or MHP. For example, the microchannel can be made of copper or other metal. Operating fluids can include de-ionized water (DI water), acetone, propanol, or other liquid.

In one example, the microchannel structures are integrated into an active die, which can distribute heat localized at a hot spot on the die to the rest of the die. In one example, the microchannel structures are integrated into a substrate or dummy die to place under an active die to spread heat localized at a hot spot of the die or localized at the die as a hot spot to other parts of the package. In one example, the microchannel structures are integrated into an IHS to spread heat localized at a hot spot of the die or localized at the die as a hot spot to other parts of the package.

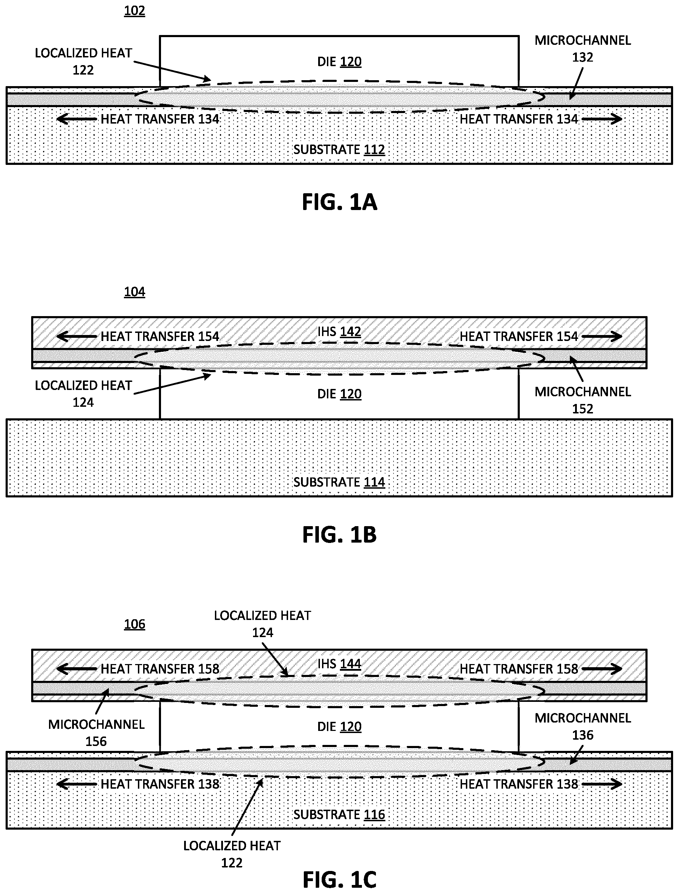

**Figure 1A** is a block diagram of an example of a system with microchannels in a substrate. System 102 represents elements of an electronic device assembly or electronic device package.

System 102 illustrates die 120 mounted or disposed on substrate 112. Die 120 represents a die of a high-performance or high-power component, such as a processor die. The processor die can be, for example, a single core processor or a multicore processor. The processor die can be or include a field programmable gate array (FPGA). The processor die can be a central processing unit (CPU). The processor die can be a graphics processing unit (GPU).

During operation, die 120 produces localized heat 122 in substrate 112. In certain active dies, it is localized heat 122 rather than overall package heat that tends to limit performance. Typically, die 120 is smaller than the package. Microchannel 132 is a microchannel integrated into or onto substrate 112. Microchannel 132 enables heat transfer 134 to spread localized heat 122 around through the package, which can improve performance of die 120.

Integration of microchannel 132 in substrate 112 can be referred to as integrating a microchannel in the silicon side of the package. In system 102, substrate 112 represents a package layer in which the microchannel is integrated.

Microchannel 132 represents a hollow heat conducting material through which a fluid will flow to spread localized heat 122. In one example, microchannel 132 has a rectangular cross section. In one example, microchannel 132 has a trapezoidal cross section. In one example, microchannel 132 has a triangular cross section. The trapezoidal cross section can be considered a triangular cross section in that a triangular structure is formed, the channel is opened on the top for processing, then the channel is sealed by another layer of material. As such, when forming a channel with a triangular cross section, a portion of the top of the triangle can be missing, resulting in a triangular cross section that could technically be considered a trapezoidal cross section.

**Figure 1B** is a block diagram of an example of a system with microchannels in an integrated heat spreader. System 104 represents elements of an electronic device assembly or electronic device package.

System 104 illustrates die 120 mounted on substrate 114, where substrate 114 does not include microchannel integrated structures. System 104 includes integrated heat spreader (IHS) 142 mounted on a top side of die 120, or a side of the die opposite the side mounted on substrate 114. IHS 142 can be considered to be mounted over die 120.

During operation, die 120 produces localized heat 124 in IHS 142. Microchannel 152 represents a microchannel integrated into or onto IHS 142. Microchannel 152 enables heat transfer 154 to spread localized heat 124 around through the package, which can improve performance of die 120.

Integration of microchannel 152 in IHS 142 can be referred to as integrating a microchannel in the IHS side of the package. In system 104, IHS 142 represents a package layer in which the microchannel is integrated. Microchannel 152 represents a hollow heat conducting material through which a fluid will flow to spread localized heat 124. In one example, microchannel 152 has a rectangular cross section. In one example, microchannel 152 has a trapezoidal cross section or triangular cross section.

**Figure 1C** is a block diagram of an example of a system with microchannels in a substrate and microchannels in an integrated heat spreader. System 106 represents elements of an electronic device assembly or electronic device package.

System 106 illustrates die 120 mounted on substrate 116. System 106 includes integrated heat spreader (IHS) 144 mounted over die 120. With microchannels in substrate 116 and in IHS 144, system 106 can cool die 120 from both sides. System 106 can be considered a system in which the die is sandwiched between heat spreading layers in the system package.

During operation, die 120 produces localized heat 122 in substrate 116 and localized heat 124 in IHS 144. Microchannel 136 is a microchannel integrated into or onto substrate 116. Microchannel 136 enables heat transfer 138 to spread localized heat 122 around through the package, which can improve performance of die 120. Microchannel 156 represents a microchannel integrated into or onto IHS 144. Microchannel 156 enables heat transfer 158 to spread localized heat 124 around through the package, which can improve performance of die 120.

Integration of microchannel 136 in substrate 116 can be referred to as integrating a microchannel in the silicon side of the package. In system 106, substrate 116 represents a package layer in which the microchannel is integrated. Microchannel 136 represents a hollow heat conducting material through which a fluid will flow to spread localized heat 122. Microchannel 136 can be open or closed, with any cross-section described.

Integration of microchannel 156 in IHS 144 can be referred to as integrating a microchannel in the IHS side of the package. In system 106, IHS 144 represents a package layer in which the microchannel is integrated. Microchannel 156 represents a hollow heat conducting material through which a fluid will flow to spread localized heat 124. Microchannel 156 can be open or closed, with any cross-section described.

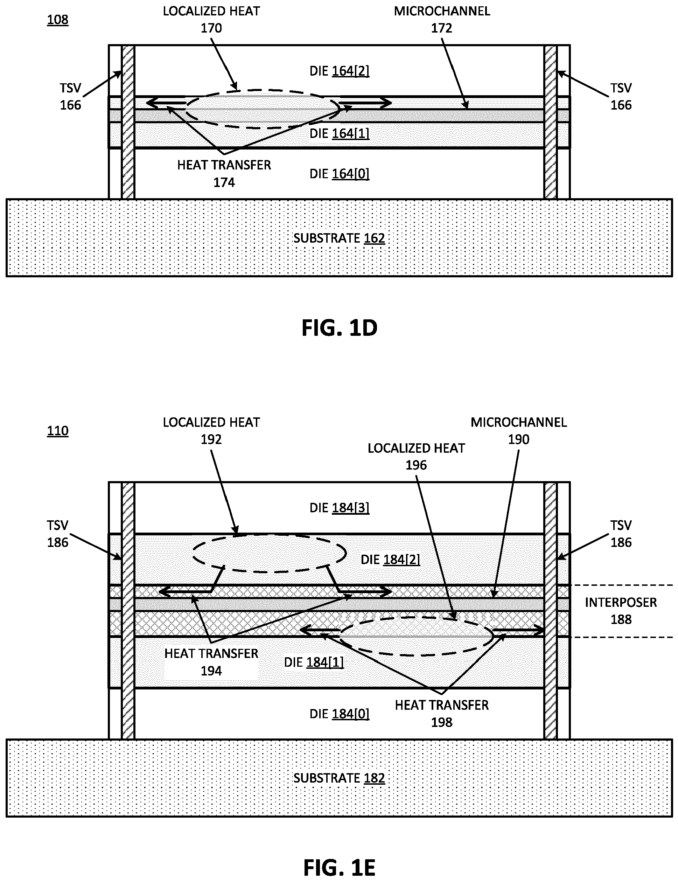

**Figure 1D** is a block diagram of an example of a system with microchannels in a substrate of a multi-die stack. System 108 represents elements of an electronic device assembly or electronic device package. System 108 represents a stacked-die architecture. In one example, system 108 represents a three-dimensional (3D) through-semiconductor-via (TSV) stacked-die architecture where stacked dies are connected with TSVs.

System 108 illustrates substrate 162 having die 164[0] directly mounted on the substrate, die 164[1] mounted on die 164[0], and die 164[2] mounted on die 164[1]. System 108 can include an IHS, which is not illustrated. The dies can collectively be referred to as dies 164[0:2] or simply dies 164. Dies 164 can be mixed components. Mixed components refers to dies that have different types, such as having memory dies stacked with processor dies, or having logic dies stacked with processing components and memory, or some other combination.

Die 164[1] is shaded to represent that the die is a high power die, which can produce localized hot spots. Dies 164 are mounted on substrate 162, and have TSVs 166 through the die stack to interconnect with substrate 162. The TSV connections can be located anywhere through the dies.

During operation, die 164[1] produces localized heat 170. In one example, die 164[1] has a microchannel structure integrated into or onto the die. In one example, microchannel 172 is integrated under the upper layers or the active layers of die 164[1]. In one example, microchannel 172 is integrated on a side of die 164[1] opposite the side on which active components are integrated. Such a microchannel would be located proximate die 164[0] in system 108.

Microchannel 172 enables heat transfer 174 to spread localized heat 170 around through the package, which can improve performance of die 164[1]. Integration of microchannel 172 in die 164[1] can be referred to as integrating a microchannel in an active die. In one example, microchannel structures can be integrated under the active components. In one example, microchannel structures can be integrated side-by-side with power traces or signal traces or both signal traces and power traces in die 164[1]. Microchannel 172 represents a hollow heat conducting material through which a fluid will flow to spread localized heat 170. Microchannel 172 can be open or closed, with any cross-section described.

**Figure 1E** is a block diagram of an example of a system with microchannels in an interposer board of a multi-die stack. System 110 represents elements of an electronic device assembly or electronic device package. System 110 represents a stacked-die architecture. In one example, system 108 represents a 3D TSV stacked-die architecture where stacked dies are connected with TSVs.

System 110 illustrates substrate 182 having die 184[0] directly mounted on the substrate, die 184[1] mounted on die 184[0], die 184[2] mounted on die 184[1] and die 184[3] mounted on die 184[2]. System 110 can include an IHS, which is not illustrated. The dies can collectively be referred to as dies 184[0:3] or simply dies 184. Dies 184 can be mixed components. Die 184[1] and die 184[2] are shaded to represent that the dies are high power dies, which can produce localized hot spots. Dies 184 are mounted on substrate 182, and have TSVs 186 through the die stack to interconnect with substrate 182. The TSV connections can be located anywhere through the dies.

During operation, die 184[1] produces localized heat 196 and die 184[2] produces localized heat 192. In one example, system 110 includes interposer 188, which represents an interposer die or interposer layer. Interposer 188 has a microchannel structure integrated into or onto the substrate or die. In one example, interposer 188 can be referred to as a dummy die, in that interposer 188 can include microchannel structures for heat spreading and not include active components. In one example, one or more passive components are integrated onto interposer (e.g., inductors or capacitors) in addition to the microchannel structures.

In one example, microchannel 190 enables heat transfer 194 to spread localized heat 192 around through the package, and heat transfer 198 to spread localized heat 196 around through the package. Integration of microchannel 190 in interposer 188 can be referred to as integrating a microchannel in a layer of the package of system 110. Microchannel 190 represents a hollow heat conducting material through which a fluid will flow to spread localized heat from the active dies. Microchannel 190 can be open or closed, with any cross-section descri bed.

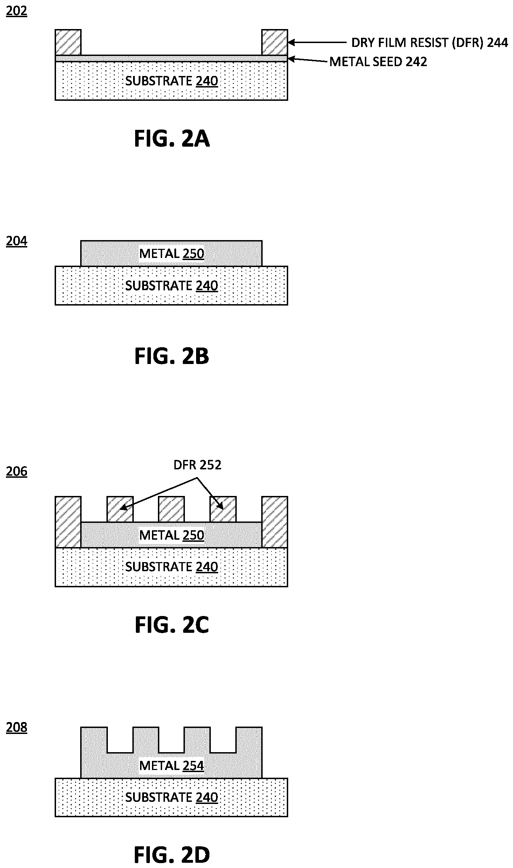

**Figures 2A-2K** represent stages in the creation of an integrated circuit with open microchannels with a rectangular cross-section.

**Figure 2A** illustrates a circuit structure for forming an integrated microchannel. Assembly 202 includes substrate 240 on which the microchannel is integrated. Metal seed 242 represents a metal seed layer deposited onto substrate 240. Dry film resist (DFR) 244 represents a photoresist or sacrificial layer to pattern structure formation. After a resist layer is deposited, the processing can expose and develop the desired pattern to result in DFR 244.

**Figure 2B** illustrates assembly 204 with metal 250 on substrate 240. The processing can plate metal 250 onto the seed layer, metal seed 242 of assembly 202, and strip the resist.

**Figure 2C** illustrates assembly 206 with DFR patterning applied. The processing can deposit a DFR laminate layer, expose, and develop the desired pattern to result in DFR 252 on metal 250.

**Figure 2D** illustrates assembly 208 with metal 254 on substrate 240. The processing can plate additional metal material onto metal 250 of assembly 206 to result in metal 254. The processing can then strip the resist.

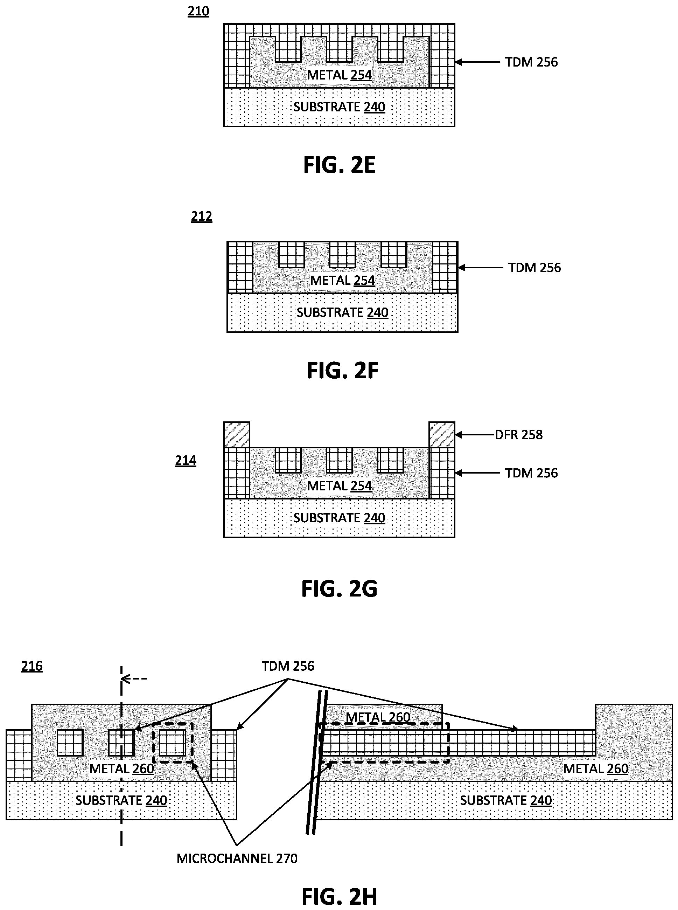

**Figure 2E** illustrates assembly 210 with a thermally decomposable polymer on the metal structure. Thermal decomposable material (TDM) 256 represents a layer of thermally decomposable polymer. TDM 256 represents a material that can be patterned or removed by the application of heat.

**Figure 2F** illustrates assembly 212 with metal 254 on substrate 240. The processing can planarize TDM 256 to leave exposed surfaces of metal 254 with structures filled with the TDM.

**Figure 2G** illustrates assembly 214 with DFR patterning applied. The processing can deposit a DFR laminate layer, expose, and develop the desired pattern to result in DFR 258 on portions of TDM 256 that are outside of metal 254.

**Figure 2H** illustrates assembly 216 with microchannel structures formed. The processing can plate additional metal material onto metal 254 of assembly 214 to result in the structure of metal 260. The processing can then strip the resist. Assembly 216 illustrates a view looking directly at the microchannels, and a cutaway view of the assembly structure. The vertical dashed line illustrates the point of the cutaway view, and the dashed arrow represents the direction of the view. In the cutaway view, it can be observed that metal 260 has an opening to microchannel 270, and TDM 256 fills the microchannel opening in metal 260.

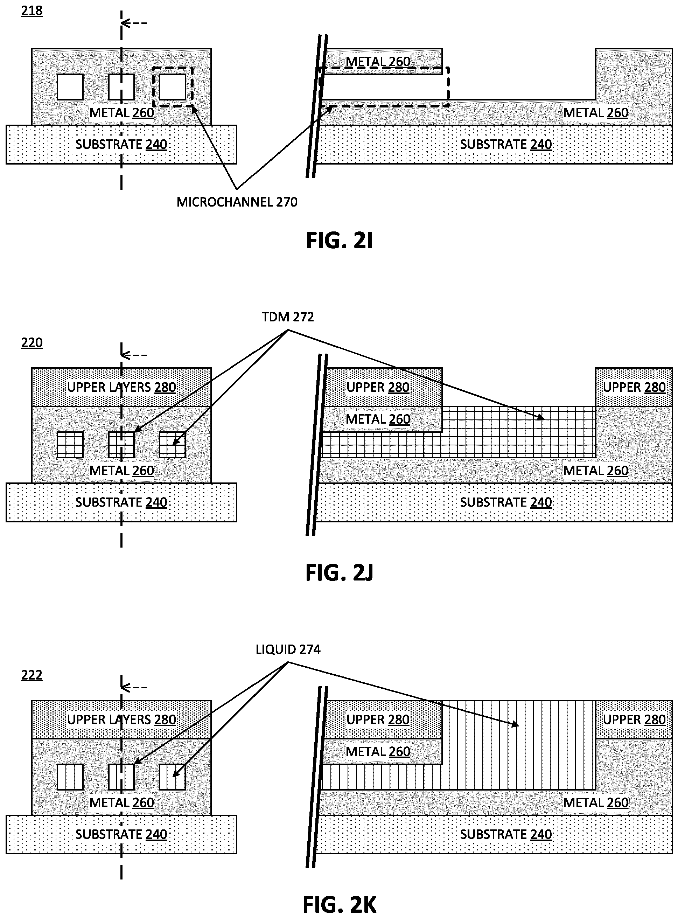

**Figure 2I** illustrates assembly 218 with microchannel structures formed. The processing can bake the circuit assembly to remove TDM 256, leaving microchannel 270 hollow. Assembly 218 illustrates that the TDM within the microchannels and outside the structure of metal 260 has been removed. In one example, the processing performs a flash etch to remove additional material from metal 260. The cutaway view illustrates that the microchannel and the opening connected to microchannel 270 have been cleared of the TDM.

**Figure 2J** illustrates assembly 220 with upper layers of the circuit formed. In one example, the processing deposits TDM 272, which fills at least a portion of the microchannels. With TDM 272 in place, the processing can complete upper layers 280, to the extent that upper layers are formed on the same circuit assembly. With TDM 272 in place, upper layers 280 can be formed without contaminating the microchannels.

**Figure 2K** illustrates assembly 222 with the microchannels filled with liquid. In one example, the processing removes TDM 272, leaving hollow microchannels, which the processing then fills with liquid 274. The liquid will flow through the microchannels. Seeing that the microchannel is open at upper layers 280, the opening to the microchannels will be sealed with a connection to a pump, which can move the fluid through the microchannels.

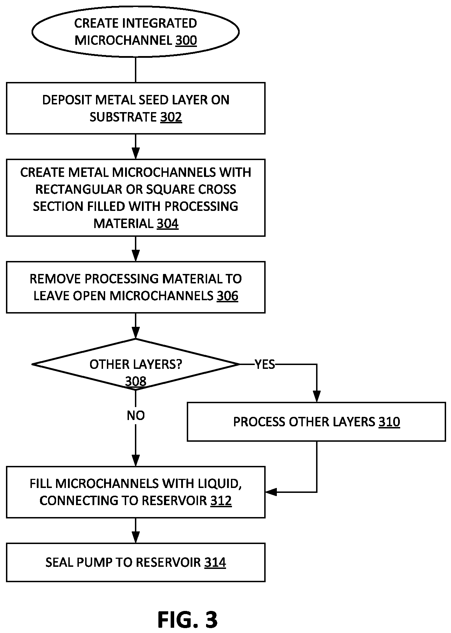

**Figure 3** is a flow diagram of an example of a process for creating an integrated circuit with open microchannels with a rectangular cross-section. Process 300 can represent a flow diagram to create a circuit assembly with an integrated microchannel in accordance with assembly 222 of Figure 2K.

In one example, the processing deposits a metal seed layer on a substrate, at 302. The processing can create metal microchannels with a rectangular or square cross-section filled with processing material, at 304. The processing material can be, for example, a thermally decomposable polymer that can be present to create the microchannel structure with the metal, and then remove from the circuit by baking or heating up the circuit to decompose the polymer and remove it from the channels. Thus, the processing can remove the processing material to leave open or hollow microchannels, at 306.

If the circuit assembly is to have other layers created above the microchannels, at 308 YES branch, the processing can process the other layers, at 310. The additional processing of the other layers can include filling the microchannels or at least the openings to the microchannels with a thermally decomposable material to keep other processing materials out of the microchannels. For circuit assemblies that are in layers dedicated to heat transfer, there may not be other layers to be built above the microchannels. Thus, if there are no other layers to create, at 308 NO branch, the processing of the layers of the circuit assembly is complete.

Once all processing on the layers of the circuit assembly is complete, whether just the layers of the microchannels, or additional layers (e.g., upper layers) on the microchannels, the processing can fill the microchannels with liquid, which connect with an opening or a reservoir of liquid, at 312. The processing can complete for the circuit assembly by sealing a pump to the reservoir or opening, to enable the pump to pump the fluid through the microchannels, at 314.

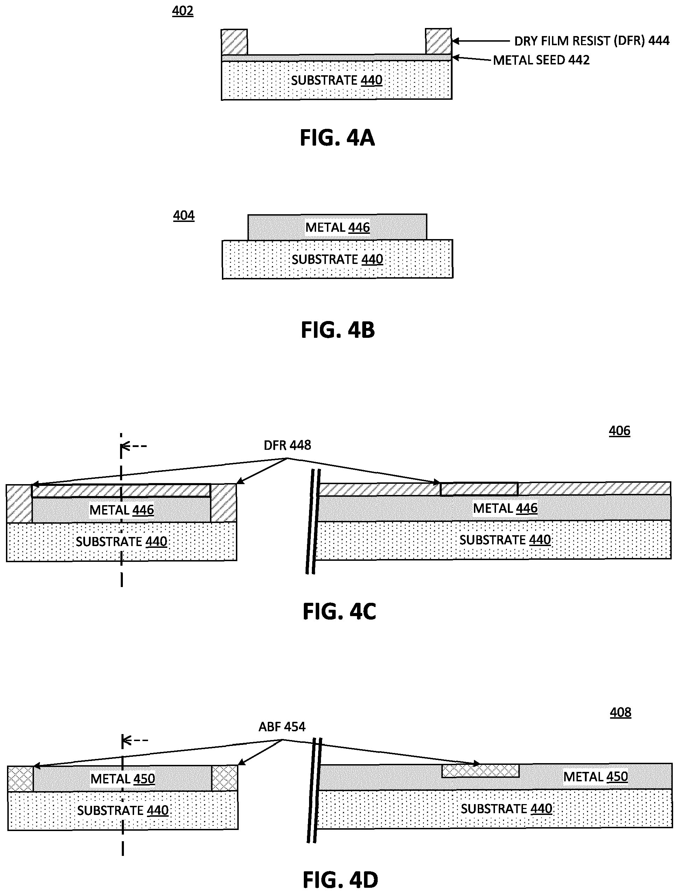

**Figures 4A-4R** represent stages in the creation of an integrated circuit with closed microchannels with a rectangular cross-section.

**Figure 4A** illustrates a circuit structure for forming an integrated microchannel. Assembly 402 includes substrate 440 on which the microchannel is integrated. Metal seed 442 represents a metal seed layer deposited onto substrate 440. Dry film resist (DFR) 444 represents a photoresist or sacrificial layer to pattern structure formation. After a resist layer is deposited, the processing can expose and develop the desired pattern to result in DFR 444.

**Figure 4B** illustrates assembly 404 with metal 446 on substrate 440. The processing can plate metal 446 onto the seed layer, metal seed 442 of assembly 402, and strip the resist.

**Figure 4C** illustrates assembly 406 with metal 446 on substrate 440. The processing can deposit DFR laminate 448 to apply a pattern for etching into metal 446. The processing can then expose and develop the pattern to prepare metal 446 for etching.

Assembly 406 illustrates a view looking directly at the metal on which the microchannels will be formed, and a cutaway view of the assembly structure. The vertical dashed line illustrates the point of the cutaway view, and the dashed arrow represents the direction of the view. In the cutaway view, it can be observed that metal 446 has portions of DFR 448 that cover selected portions of metal, and DFR that surrounds the metal.

**Figure 4D** illustrates assembly 408 with metal 450 with etched portions. The processing can remove DFR 448, and flash etch metal 446 to create metal 450, which includes portions that have been etched. The processing can deposit a dielectric laminate represented by ABF 454, which will surround metal 450 and fill the etched portions. ABF 454 generally represents a dielectric layer. In one example, the dielectric is an ABF (Ajinomoto build-up film) laminate layer. ABF is a low-loss dielectric. In one example, the ABF material is replaced with a different type of dielectric. The cutaway view on the right of the diagram illustrates ABF 454 in an etched portion of metal 450.

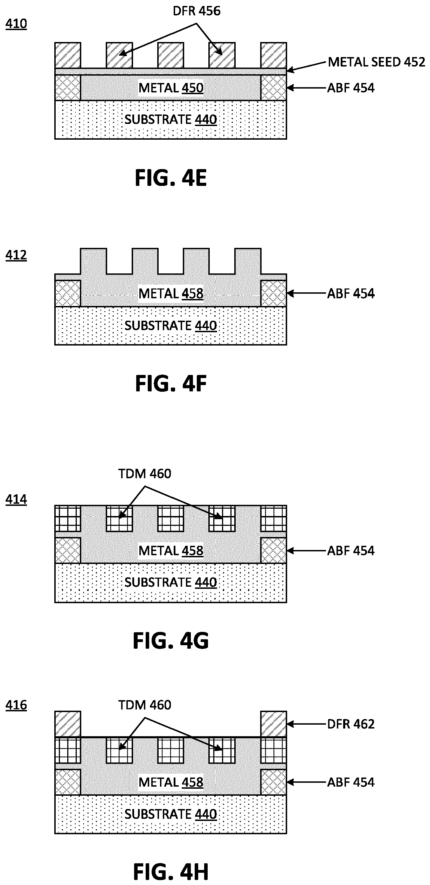

**Figure 4E** illustrates assembly 410 with DFR patterning applied. The processing can deposit metal seed 452 to prepare for metal deposition. The processing can deposit a DFR laminate layer, expose, and develop the desired pattern to result in DFR 456 on metal seed 452, over ABF 454 and metal 450.

**Figure 4F** illustrates assembly 412 with metal 458 on substrate 440. The processing can plate additional metal material onto metal 450 of assembly 410 to result in metal 458. The processing can then strip the resist. In one example, ABF 454 remains between the metal seed and substrate 440.

**Figure 4G** illustrates assembly 414 with a thermally decomposable polymer on the metal structure. Thermal decomposable material (TDM) 460 represents a layer of thermally decomposable polymer. TDM 460 represents a material that can be patterned or removed by the application of heat. The processing can planarize the assembly to leave exposed surfaces of metal 458 with structures filled with the TDM. TDM 460 can fill the patterned areas of metal 458.

**Figure 4H** illustrates assembly 416 with metal 458 on substrate 440. The processing can deposit a DFR laminate layer, expose, and develop the desired pattern to result in DFR 462 on TDM 460.

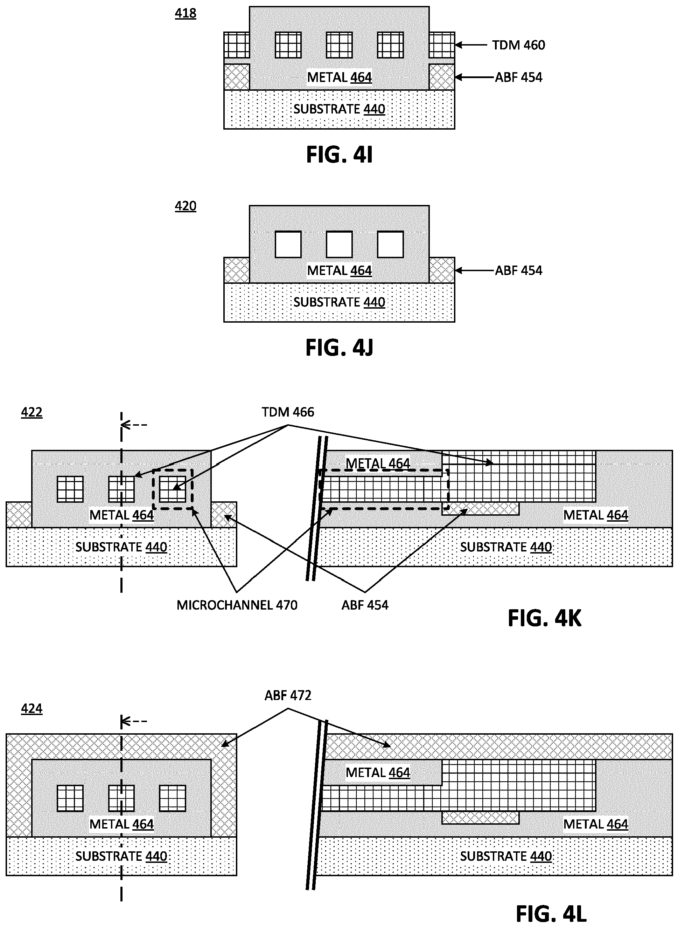

**Figure 4I** illustrates assembly 418 with microchannel structures formed. The processing can plate additional metal material onto metal 458 of assembly 416 to result in the structure of metal 464. The processing can then strip the resist.

**Figure 4J** illustrates assembly 420 with open microchannel structures formed. The processing can remove TDM 460, and flash etch to remove the artifacts of the metal seed layer. The resulting metal structure with microchannels is illustrated in assembly 420 by metal 464. ABF 454 can remain in the assembly.

**Figure 4K** illustrates assembly 422 with a thermally decomposable polymer in the microchannels. The processing can deposit TDM 466 to fill at least a portion of the microchannels. The view on the left represents a view directly at one of microchannels 470. The cutaway view illustrates microchannel 470 filled with TDM 466. It can be observed from the cutaway view that there is an opening in metal 464 to allow access to microchannel 470. At the bottom of the opening in metal 464, near a start of microchannel 470, is ABF 454.

**Figure 4L** illustrates assembly 424 with a dielectric layer. The processing can deposit ABF 472 to cover and surround the microchannel structure of metal 464. The cutaway view illustrates that ABF 472 covers metal 464 and the TDM exposed in the opening of metal 464.

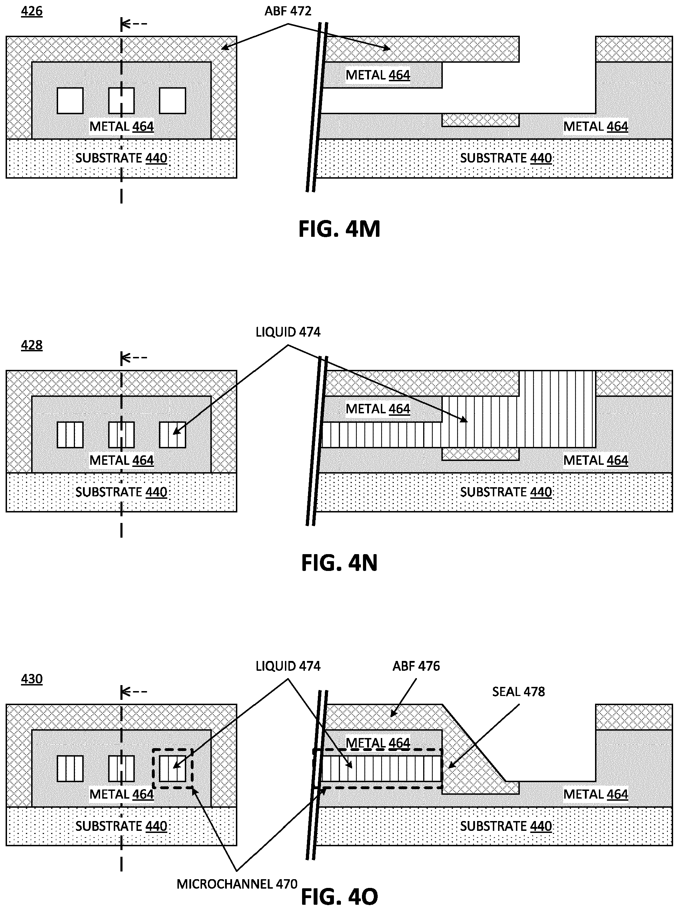

**Figure 4M** illustrates assembly 426 with open microchannel structures formed. The processing can make an opening in ABF 472, and bake the circuit assembly to remove TDM 466, leaving microchannel 470 hollow. Assembly 426 illustrates that the TDM within the microchannels has been removed. The cutaway view illustrates the opening in ABF 472 and the empty space in the microchannels and in the opening of metal 464 adjacent the microchannels.

**Figure 4N** illustrates assembly 428 with the microchannels filled with liquid. In one example, the processing fills microchannels 470 with liquid 474. The liquid will flow through the microchannels during operation. The cutaway view illustrates that liquid 474 fills the microchannels and the reservoir area or the open area in metal 464.

In one example, liquid 474 is hot DI water, or other liquid that is heated. Heating the liquid to fill the microchannels can prevent over-filling the channels. Using cooled liquid will restrict the flow of the liquid because there will be excess pressure resisting the diffusion of the liquid through the microchannels in response to heat transfer.

The heat transfer occurs as the liquid heats up due to the localized heat, expanding and flowing due to capillary action or wicking through the microchannel. As the liquid moves to cooler areas, it transfers heat through the structure of the metal or heat transfer material, causing the liquid to compress. Thus, filling the microchannels with heated liquid prior to sealing the microchannels can ensure the proper amount of liquid is sealed in the microchannel structures for heat transfer.

**Figure 4O** illustrates assembly 430 with the microchannels sealed. In one example, the processing heats the assembly to generate a mixture of liquid and liquid vapor (e.g., DI water and steam), and presses ABF 472 into the shape of ABF 476, as seen in the cutaway view. As seen in assembly 430, microchannels 470 are filled with liquid 474, and they are sealed with seal 478. In one example, ABF 476 or other dielectric can be engineered to flow or bend in a desired way at the temperature used to heat the assembly for sealing the mixture of liquid and liquid vapor. Pressing the ABF into the structure of ABF 476 can seal the microchannels closed. It can be observed that ABF 476 includes seal 478, which is a combination of ABF 472 that was deposited on metal 464, and ABF 454 that was deposited into the etched area of the metal. The seal can be a hermetic seal, preventing the escape of liquid 474.

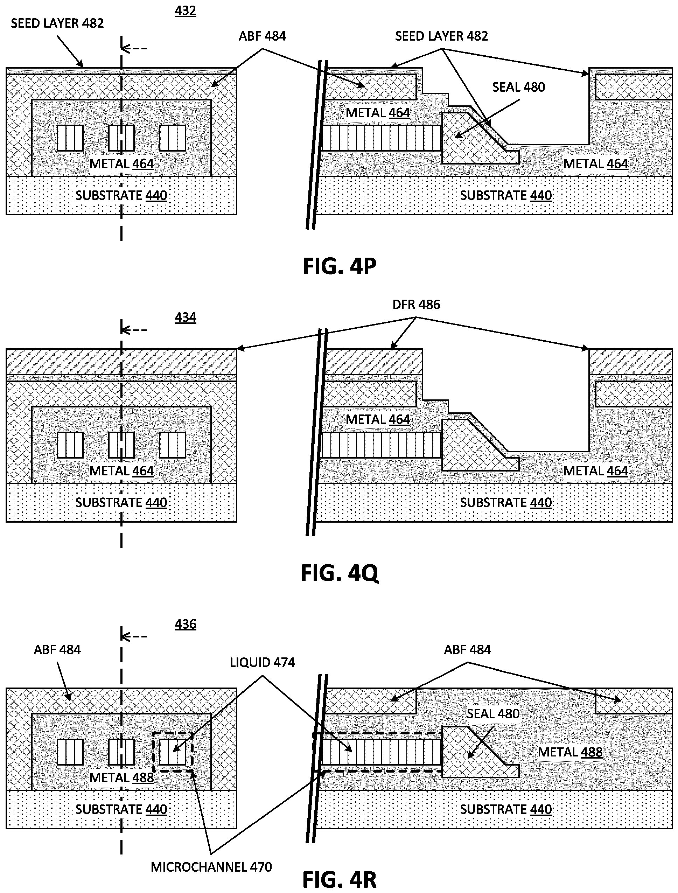

**Figure 4P** illustrates assembly 432 with a metal seed layer. In one example, the processing performs a laser skive to remove excess material from the assembly. For example, the processing can remove some material from ABF 484 to separate seal 480 from the rest of the ABF. The processing can then deposit seed layer 482, which is a metal seed layer.

The cutaway view illustrates the separation of seal 480 from ABF 484. From the cutaway view it can also be seen that the microchannels are filled with liquid, which is sealed with seal 480, and then seal 480 is covered with seed layer 482.

**Figure 4Q** illustrates assembly 434 with patterning layer deposited. In one example, the processing deposits a DFR laminate, illustrated by DFR 486, which is formed on top of the circuit assembly. The processing can deposit a DFR laminate layer, expose, and develop the desired pattern to result in DFR 486 on seed layer 482, over metal 464 and substrate 440. The cutaway view illustrates an opening in DFR 486 to expose the seed layer over metal 464 where the seal over the microchannels is located.

**Figure 4R** illustrates assembly 436 to complete the assembly. In one example, the processing plates the metal, and performs a strip and flash etch to remove excess material. The processing results in metal 488. Metal 488 provides a metal seal over seal 480, to ensure that even in higher temperature conditions, seal 480 should maintain integrity, keeping liquid 474 in microchannel 470. ABF 484 can remain over the structure of metal 488. Thus, assembly 436 includes completely sealed microchannels that have liquid in them. The cutaway view illustrates that metal 488 can be level with ABF 484 above seal 480. If other layers (e.g., upper layers) are to be formed over the microchannels, the processing can continue to create the upper layers of components.

Assembly 436 can provide sealed, hollow structures filled with a working fluid, which can be considered a heat pipe. The heat pipe can dissipate from local hot spots of the package to other areas of the package. As seen, the working fluid is contained by forming the microchannel structure, which is a hollow channel with a small cross-section, formed by integrated circuit processes. The seal on the microchannels can be created by use of a soft or deformable material (e.g., dielectric, polymer, or other material) that is adjacent or connected to the microchannel. The deformable material can be pressed to form the seal. The seal is then reinforced with a hard enclosure, such as the metal of the heat transfer structure capping the seal, which reinforces the hermetic seal and provides structural support to the seal.

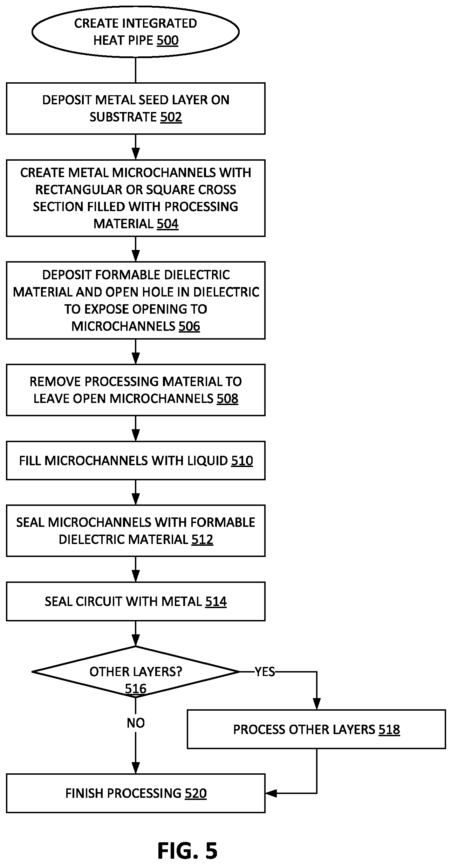

**Figure 5** is a flow diagram of an example of a process for creating an integrated circuit with closed microchannels with a rectangular cross-section. Process 500 can represent a flow diagram to create a circuit assembly with a sealed, integrated microchannel in accordance with assembly 436 of Figure 4R.

In one example, the processing deposits a metal seed layer on a substrate, at 502. The processing can create metal microchannels with a rectangular or square cross-section filled with processing material, at 504. The processing material can be, for example, a thermally decomposable polymer that can be present to create the microchannel structure with the metal, and then remove from the circuit by baking or heating up the circuit to decompose the polymer and remove it from the channels.

In one example, the processing deposits a formable or deformable dielectric or polymer material and open a hole in the dielectric material to expose an opening to the microchannels, at 506. In one example, the processing can remove the processing material to leave open or hollow microchannels, at 508.

The processing can fill the microchannels with a liquid or working fluid, at 510. The liquid will flow through the microchannels in response to heat to transfer heat from hot spots to other areas of the package. The processing seals the microchannels with the formable dielectric material, at 512. The processing can then seal the circuit with metal or other material to provide structural support and reinforce the seal on the microchannels, at 514.

If the circuit assembly is to have other layers created above the microchannels, at 516 YES branch, the processing can process the other layers, at 518. For circuit assemblies that are in layers dedicated to heat transfer, there may not be other layers to be built above the microchannels. Thus, if there are no other layers to create, at 516 NO branch, the processing of the layers of the circuit assembly is complete. Once all processing on the layers of the circuit assembly is complete, whether just the layers of the microchannels, or additional layers (e.g., upper layers) on the microchannels, the processing can finish, at 520.

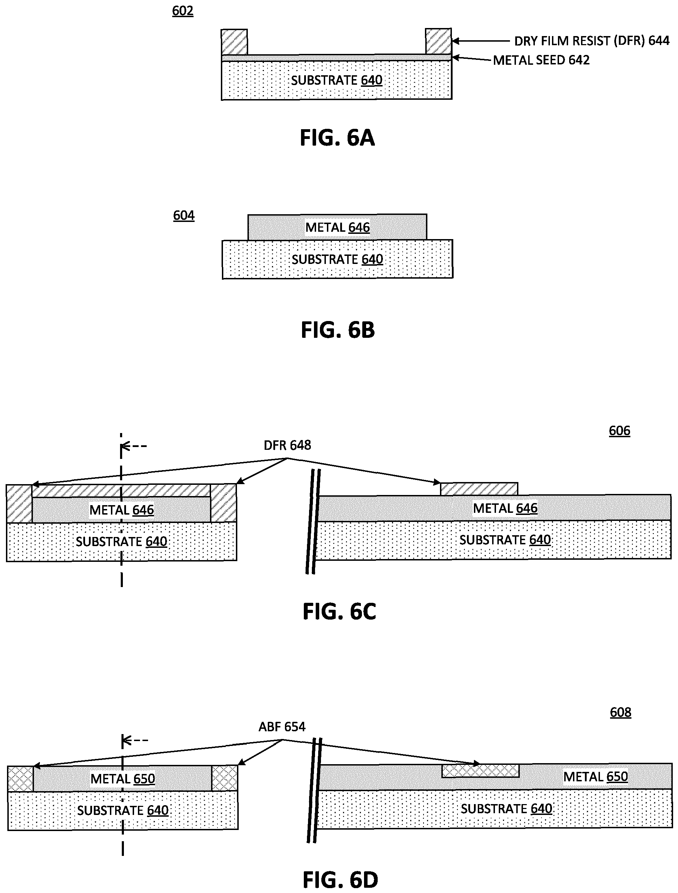

**Figures 6A-6R** represent stages in the creation of an integrated circuit with closed microchannels with a triangular cross-section.

**Figure 6A** illustrates a circuit structure for forming an integrated microchannel. Assembly 602 includes substrate 640 on which the microchannel is integrated. Metal seed 642 represents a metal seed layer deposited onto substrate 640. Dry film resist (DFR) 644 represents a photoresist or sacrificial layer to pattern structure formation. After a resist layer is deposited, the processing can expose and develop the desired pattern to result in DFR 644.

**Figure 6B** illustrates assembly 604 with metal 646 on substrate 640. The processing can plate metal 646 onto the seed layer, metal seed 642 of assembly 602, and strip the resist.

**Figure 6C** illustrates assembly 606 with metal 646 on substrate 640. The processing can deposit DRF laminate 648 to apply a pattern for etching into metal 646. The processing can then expose and develop the pattern to prepare metal 646 for etching.

Assembly 606 illustrates a view looking directly at the metal on which the microchannels will be formed, and a cutaway view of the assembly structure. The vertical dashed line illustrates the point of the cutaway view, and the dashed arrow represents the direction of the view. In the cutaway view, it can be observed that metal 646 has portions of DFR 648 that cover selected portions of metal, and DFR that surrounds the metal.

**Figure 6D** illustrates assembly 608 with metal 650 with etched portions. The processing can remove DFR 648, and flash etch metal 646 to create metal 650, which includes portions that have been etched. The processing can deposit a dielectric laminate represented by ABF 654, which will surround metal 650 and fill the etched portions. ABF 654 generally represents a dielectric layer. In one example, the dielectric is an ABF (Ajinomoto build-up film) laminate layer. ABF is a low-loss dielectric. In one example, the ABF material is replaced with a different type of dielectric. The cutaway view on the right of the diagram illustrates ABF 654 in an etched portion of metal 650.

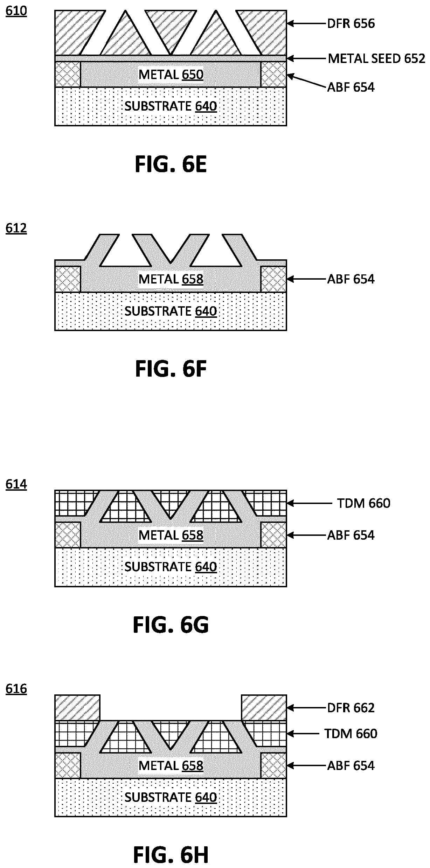

**Figure 6E** illustrates assembly 610 with DFR patterning applied. The processing can deposit metal seed 652 to prepare for metal deposition. The processing can deposit a DFR laminate layer, expose, and develop the desired pattern to result in DFR 656 on metal seed 652, over ABF 654 and metal 650. The structure of DFR 656 with the openings at angles relative to the plane of substrate 640 can be formed by application an optical heat source or laser through a prism.

**Figure 6F** illustrates assembly 612 with metal 658 on substrate 640. The processing can plate additional metal material onto metal 650 of assembly 610 to result in metal 658. The processing can then strip the resist. In one example, ABF 654 remains between the metal seed and substrate 640. Because of the angled openings of DFR 656, plating the metal results in structures of metal 658 that have acute angles with respect to the plane of substrate 640. Thus, the angles at the surface of the original metal plane of metal 650 meets the vertical metal structures at angles that form a channel having sidewalls that are at acute angles, forming a triangular shape. The triangle is not fully formed due to opening the top of the structure to allow the processing of additional materials; thus, the triangular shape is technically a trapezoidal shape, which can be considered comparable structures for purposes of the processing described here.

**Figure 6G** illustrates assembly 614 with a thermally decomposable polymer on the metal structure. Thermal decomposable material (TDM) 660 represents a layer of thermally decomposable polymer. TDM 660 represents a material that can be patterned or removed by the application of heat. The processing can planarize the assembly to leave exposed surfaces of metal 658 with triangular structures filled with the TDM. TDM 660 can fill the patterned areas of metal 658.

**Figure 6H** illustrates assembly 616 with metal 658 on substrate 640. The processing can deposit a DFR laminate layer, expose, and develop the desired pattern to result in DFR 662 on TDM 660.

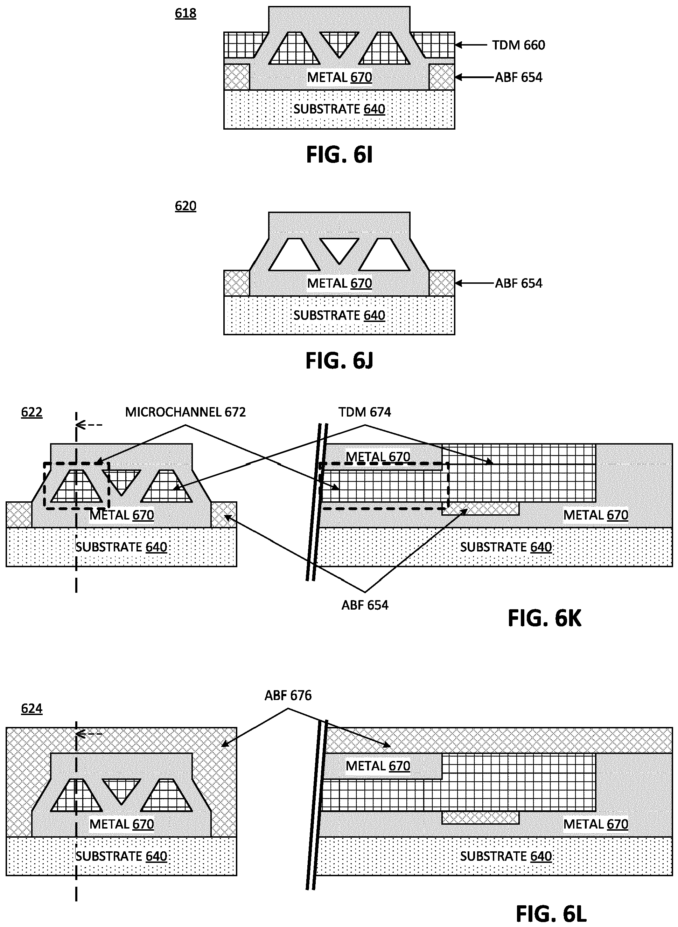

**Figure 6I** illustrates assembly 618 with microchannel structures formed. The processing can plate additional metal material onto metal 658 of assembly 616 to result in the structure of metal 670. Metal 670 has the completed structure of the channels with triangular or trapezoidal cross sections. The processing can then strip the resist.

**Figure 6J** illustrates assembly 620 with open microchannel structures formed. The processing can remove TDM 660, and flash etch to remove the artifacts of the metal seed layer. The resulting metal structure with microchannels is illustrated in assembly 620 by metal 670. ABF 654 can remain in the assembly.

**Figure 6K** illustrates assembly 622 with a thermally decomposable polymer in the microchannels. The processing can deposit TDM 674 to fill at least a portion of the microchannels. The view on the left represents a view directly at one of microchannels 672. The cutaway view illustrates microchannel 672 filled with TDM 674. It can be observed from the cutaway view that there is an opening in metal 670 to allow access to microchannel 672. At the bottom of the opening in metal 670, near a start of microchannel 672, is ABF 654.

**Figure 6L** illustrates assembly 624 with a dielectric layer. The processing can deposit ABF 676 to cover and surround the microchannel structure of metal 670. The cutaway view illustrates that ABF 676 covers metal 670 and the TDM exposed in the opening of metal 670.

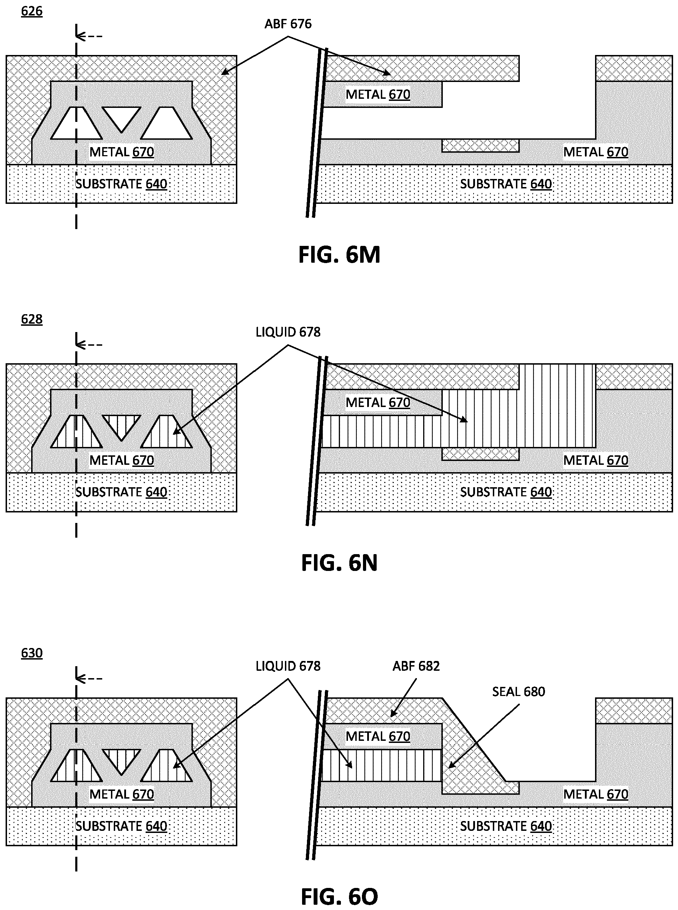

**Figure 6M** illustrates assembly 626 with open microchannel structures formed. The processing can make an opening in ABF 676, and bake the circuit assembly to remove TDM 674, leaving microchannel 672 hollow. Assembly 626 illustrates that the TDM within the microchannels has been removed. The cutaway view illustrates the opening in ABF 676 and the empty space in the microchannels and in the opening of metal 670 adjacent the microchannels.

**Figure 6N** illustrates assembly 628 with the microchannels filled with liquid. In one example, the processing fills microchannels 672 with liquid 678. The liquid will flow through the microchannels during operation. The cutaway view illustrates that liquid 678 fills the microchannels and the reservoir area or the open area in metal 670.

In one example, liquid 678 is hot DI water, or other liquid that is heated. Heating the liquid to fill the microchannels can prevent over-filling the channels. Using cooled liquid will restrict the flow of the liquid because there will be excess pressure resisting the diffusion of the liquid through the microchannels in response to heat transfer.

The heat transfer occurs as the liquid heats up due to the localized heat, expanding and flowing due to capillary action or wicking through the microchannel. As the liquid moves to cooler areas, it transfers heat through the structure of the metal or heat transfer material, causing the liquid to compress. Thus, filling the microchannels with heated liquid prior to sealing the microchannels can ensure the proper amount of liquid is sealed in the microchannel structures for heat transfer.

**Figure 6O** illustrates assembly 630 with the microchannels sealed. In one example, the processing heats the assembly to generate a mixture of liquid and liquid vapor (e.g., DI water and steam), and presses ABF 676 into the shape of ABF 682, as seen in the cutaway view. As seen in assembly 630, microchannels 672 are filled with liquid 678, and they are sealed with seal 680 to cap the microchannel. In one example, ABF 676 or other dielectric can be engineered to flow or bend in a desired way at the temperature used to heat the assembly for sealing the mixture of liquid and liquid vapor. Pressing the ABF into the structure of ABF 682 can seal the microchannels closed. It can be observed that ABF 682 includes seal 680, which is a combination of ABF 676 that was deposited on metal 670, and ABF 654 that was deposited into the etched area of the metal. The seal can be a hermetic seal, preventing the escape of liquid 678.

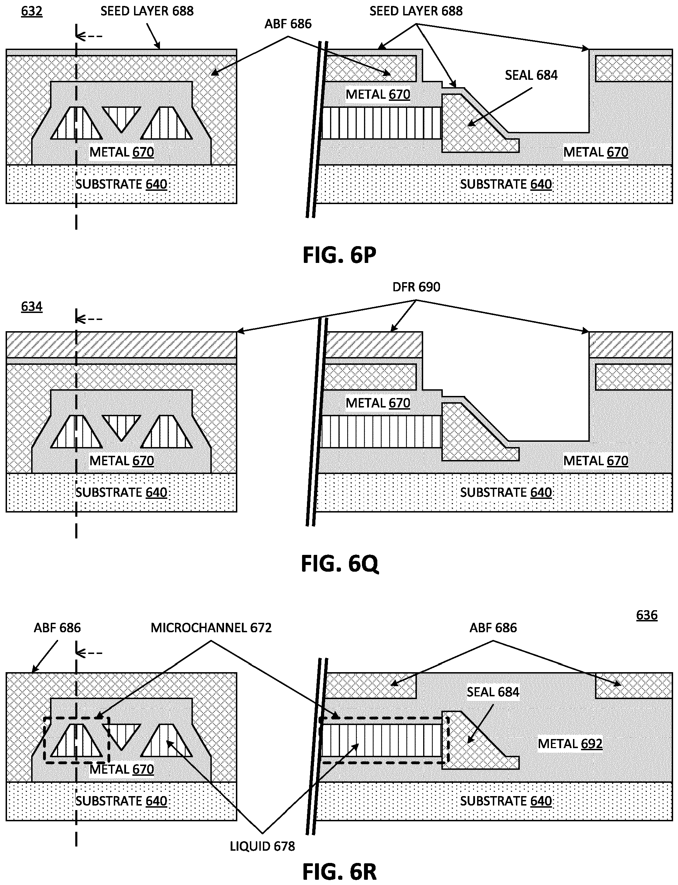

**Figure 6P** illustrates assembly 632 with a metal seed layer. In one example, the processing performs a laser skive to remove excess material from the assembly. For example, the processing can remove some material from ABF 686 to separate seal 684 from the rest of the ABF. The processing can then deposit seed layer 688, which is a metal seed layer.

The cutaway view illustrates the separation of seal 684 from ABF 686. From the cutaway view it can also be seen that the microchannels are filled with liquid, which is sealed with seal 684, and then seal 684 is covered with seed layer 688.

**Figure 6Q** illustrates assembly 634 with patterning layer deposited. In one example, the processing deposits a DFR laminate, illustrated by DFR 690, which is formed on top of the circuit assembly. The processing can deposit a DFR laminate layer, expose, and develop the desired pattern to result in DFR 690 on seed layer 688, over metal 670 and substrate 640. The cutaway view illustrates an opening in DFR 690 to expose the seed layer over metal 670 where the seal over the microchannels is located.

**Figure 6R** illustrates assembly 636 to complete the assembly. In one example, the processing plates the metal, and performs a strip and flash etch to remove excess material. The processing results in metal 692. Metal 692 provides a metal seal over seal 684, to ensure that even in higher temperature conditions, seal 684 should maintain integrity, keeping liquid 678 in microchannel 672. ABF 686 can remain over the structure of metal 692. Thus, assembly 636 includes completely sealed microchannels that have liquid in them. The cutaway view illustrates that metal 692 can be level with ABF 686 above seal 684. If other layers (e.g., upper layers) are to be formed over the microchannels, the processing can continue to create the upper layers of components.

Assembly 636 can provide sealed, hollow structures filled with a working fluid, which can be considered a heat pipe. The heat pipe can dissipate from local hot spots of the package to other areas of the package. As seen, the working fluid is contained by forming the microchannel structure, which is a hollow channel with a small cross-section, formed by integrated circuit processes. The seal on the microchannels can be created by use of a soft or deformable material (e.g., dielectric, polymer, or other material) that is adjacent or connected to the microchannel. The deformable material can be pressed to form the seal. The seal can be capped to be reinforced with a hard enclosure, such as the metal of the heat transfer structure, which reinforces the hermetic seal and provides structural support to the seal.

The triangular shape of microchannels 672 can provide superior wicking or diffusion compared to rectangular structures. The triangular microchannels are not as easy to manufacture as those with rectangular or square cross sections, but provide better capillary action. The triangular shape can thus be preferable for heat transfer with closed heat pipes, although rectangular or square cross sections will also work. The triangular shape would be less preferred for open microchannel because the capillary action would increase the drag on the pumping of working fluid. The triangular shape is possible for open microchannels, even though it may be less efficient.

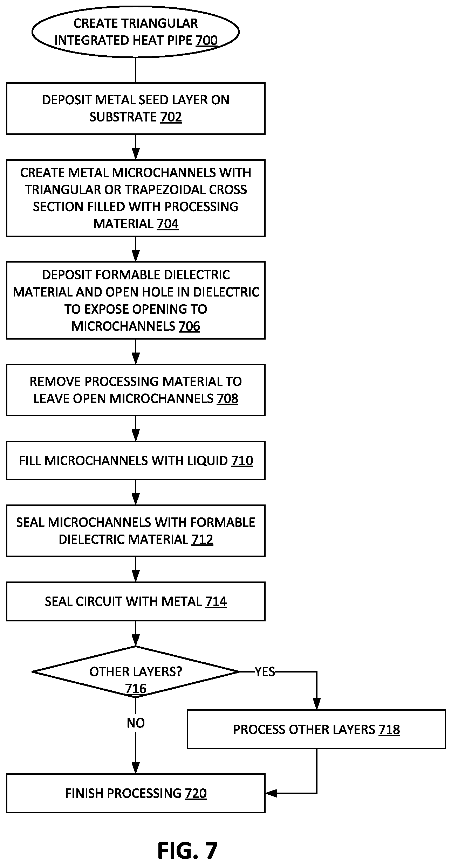

**Figure 7** is a flow diagram of an example of a process for creating an integrated circuit with closed microchannels with a triangular cross-section. Process 700 can represent a flow diagram to create a circuit assembly with a sealed, integrated microchannel in accordance with assembly 636 of Figure 6R.

In one example, the processing deposits a metal seed layer on a substrate, at 702. The processing can create metal microchannels with a triangular or trapezoidal (e.g., a triangle with a portion of the top of the triangle removed for integrated processing) cross-section filled with processing material, at 704. The processing material can be, for example, a thermally decomposable polymer that can be present to create the microchannel structure with the metal, and then remove from the circuit by baking or heating up the circuit to decompose the polymer and remove it from the channels.

In one example, the processing deposits a formable or deformable dielectric or polymer material and open a hole in the dielectric material to expose an opening to the microchannels, at 706. In one example, the processing can remove the processing material to leave open or hollow microchannels, at 708.

The processing can fill the microchannels with a liquid or working fluid, at 710. The liquid will flow through the microchannels in response to heat to transfer heat from hot spots to other areas of the package. The processing seals the microchannels with the formable dielectric material, at 712. The processing can then seal the circuit with metal or other material to provide structural support and reinforce the seal on the microchannels, at 714.

If the circuit assembly is to have other layers created above the microchannels, at 716 YES branch, the processing can process the other layers, at 718. For circuit assemblies that are in layers dedicated to heat transfer, there may not be other layers to be built above the microchannels. Thus, if there are no other layers to create, at 716 NO branch, the processing of the layers of the circuit assembly is complete. Once all processing on the layers of the circuit assembly is complete, whether just the layers of the microchannels, or additional layers (e.g., upper layers) on the microchannels, the processing can finish, at 720.

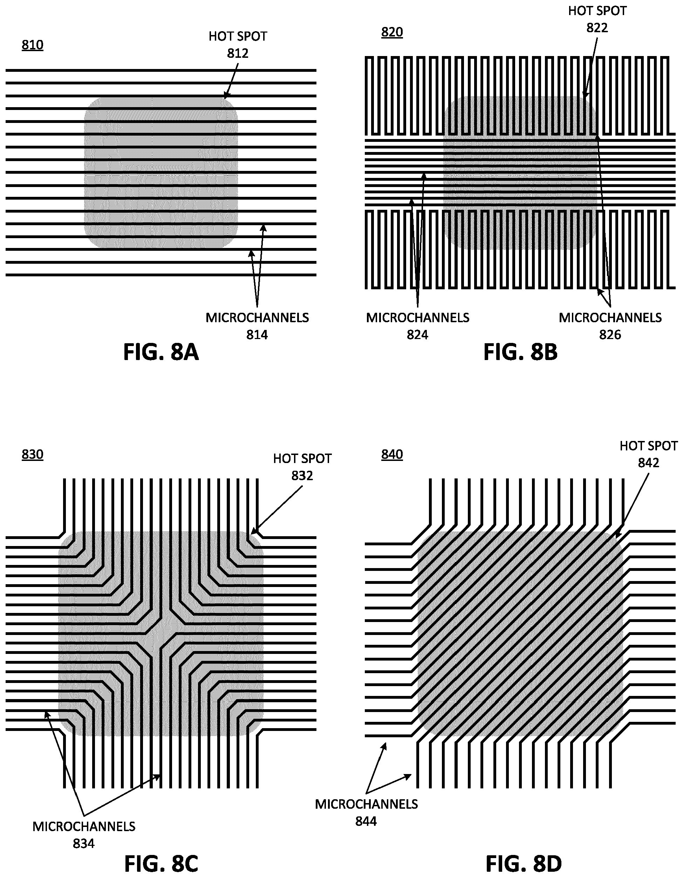

**Figure 8A** is a block diagram of an example of a system with straight microchannels to spread heat from a hot spot. Diagram 810 represents a two-dimensional (2D) design or configuration of microchannels to remove heat from a hot spot. The dimensions are not necessarily to scale, but are intended simply to show the pattern. The shaded area represents hot spot 812. Hot spot 812 can represent an entire die or a portion of a die. Reference to a hot spot can refer to a chip that could experience hot spots in different parts of the chip. Thus, the microchannel pattern can run under a chip that could experience hot spots in all or a portion of the chip. Microchannels 814 represent parallel, straight-line, embedded structures. Microchannels 814 can be connected to a pump or can be sealed in the integration processing. Microchannels 814 can be of different sizes and structures, depending on the implementation.

**Figure 8B** is a block diagram of an example of a system with microchannels having a serpentine pattern to spread heat from a hot spot. Diagram 820 represents a 2D design or configuration of microchannels to remove heat from a hot spot. The dimensions are not necessarily to scale, but are intended simply to show the pattern. The shaded area represents hot spot 822. Hot spot 822 can represent an entire die or a portion of a die. Microchannels 824 represent parallel, straight-line, embedded structures. Microchannels 826 represent embedded structures in a serpentine pattern. Microchannels 824 and microchannels 826 can be connected to a pump or can be sealed in the integration processing. Microchannels 824 and microchannels 826 can be of different sizes and structures, depending on the implementation. Diagram 820 illustrates a configuration where different microchannel patterns are used together. Any number of 2D patterns can be used together and are not limited to straight lines and serpentine patterns.

**Figure 8C** is a block diagram of an example of a system with another microchannel pattern to spread heat from a hot spot. Diagram 830 represents a two-dimensional (2D) design or configuration of microchannels to remove heat from a hot spot. The shaded area represents hot spot 832. Hot spot 832 can represent an entire die or a portion of a die. The dimensions are not necessarily to scale, but are intended simply to show the pattern. Microchannels 834 represent parallel embedded structures. More specifically, microchannels 834 extend from hot spot 832 toward two different portions of the package, with approximately 90 degrees between the two legs or two branches of the microchannels. As such, microchannels 834 can be laid out in four different quadrants. Microchannels 834 can be connected to a pump or can be sealed in the integration processing. Microchannels 834 can be of different sizes and structures, depending on the implementation.

**Figure 8D** is a block diagram of an example of a system with another microchannel pattern to spread heat from a hot spot. Diagram 840 represents a two-dimensional (2D) design or configuration of microchannels to remove heat from a hot spot. The shaded area represents hot spot 842. Hot spot 842 can represent an entire die or a portion of a die. The dimensions are not necessarily to scale, but are intended simply to show the pattern. Microchannels 844 represent parallel embedded structures. More specifically, microchannels 844 extend from hot spot 842 toward two different portions of the package, with approximately 90 degrees between the two legs or two branches of the microchannels, with a diagonal portion of the microchannel that cuts across the hot spot at approximately 45 degrees with respect to the two legs or branches of the microchannels. As such, microchannels 844 can be laid out in two different portions to cover hot spot 842. Microchannels 844 can be connected to a pump or can be sealed in the integration processing. Microchannels 844 can be of different sizes and structures, depending on the implementation.

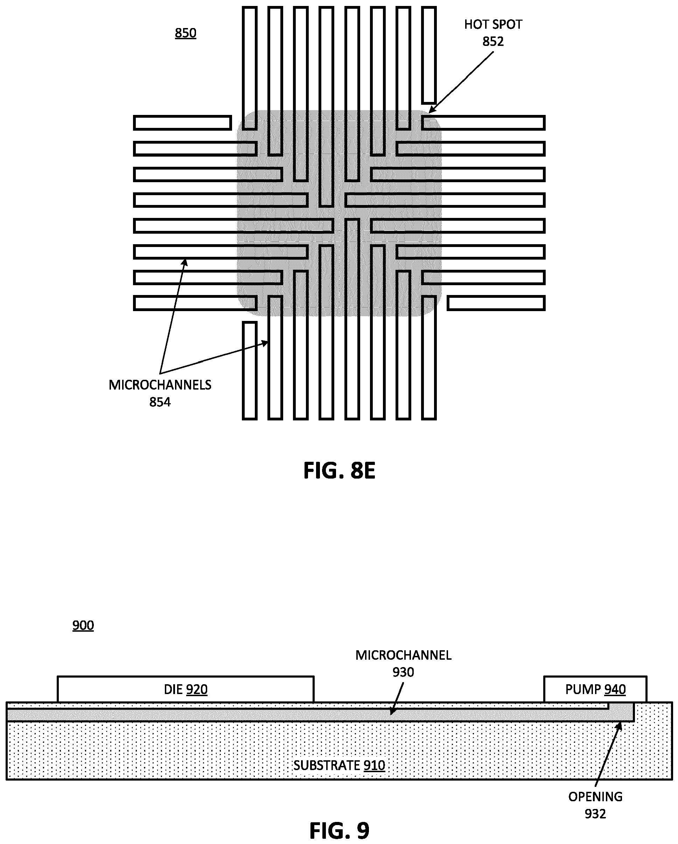

**Figure 8E** is a block diagram of an example of a system with closed loop microchannel patterns to spread heat from a hot spot. Diagram 850 represents a two-dimensional (2D) design or configuration of microchannels to remove heat from a hot spot. The dimensions are not necessarily to scale, but are intended simply to show the pattern. The shaded area represents hot spot 852. Hot spot 852 can represent an entire die or a portion of a die. Microchannels 854 represent closed loop embedded structures. More specifically, microchannels 854 have parallel portions extending between hot spot 852 and a different part of the package, where the parallel portions are connected on each end. The 2D pattern of the closed loops can be any pattern.

**Figure 9** is a block diagram of an example of a system with a pump for a substrate with open microchannels. System 900 represents an example of a system with substrate 910 having integrated microchannel structures. Microchannel 930 represents the microchannel structures integrated into or onto substrate 910. Die 920 represents an active die mounted on substrate 910. During operation, die 920 will produce localized heat that can be spread with microchannel 930.

Microchannel 930 has opening 932 at one part of the microchannel. Pump 940 seals opening 932 to be able to pump working fluid through microchannel 930 to transfer heat localized at die 920 to other areas of system 900 in other parts of the system packaging. With opening 932, microchannel 930 can be considered an open microchannel to allow a connection to pump 940.

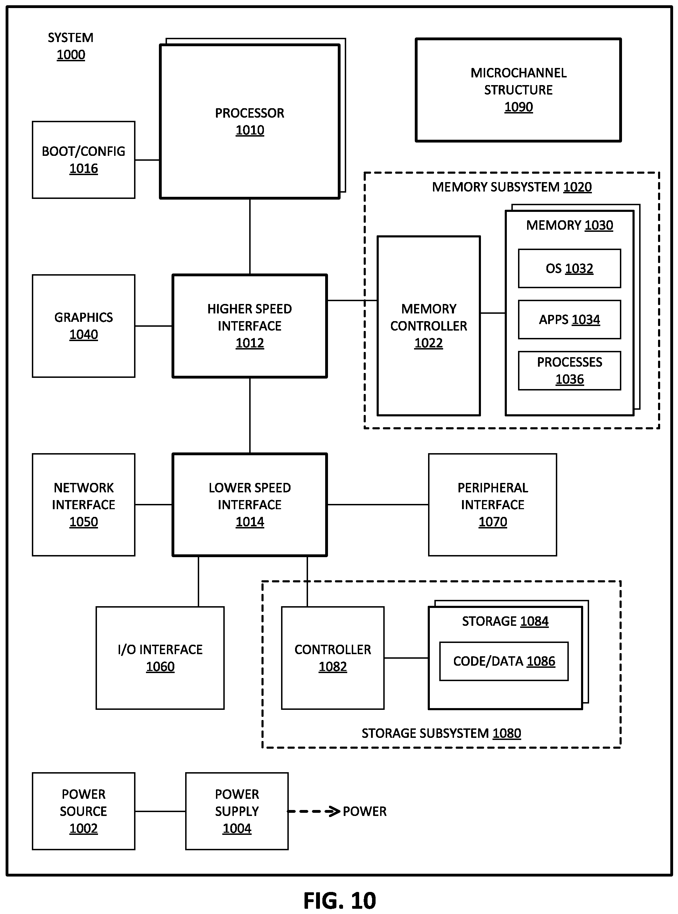

**Figure 10** is a block diagram of an example of a computing system in which an integrated microchannel heat spreader can be implemented. System 1000 represents a computing device in accordance with any example herein, and can be a laptop computer, a desktop computer, a tablet computer, a server, a gaming or entertainment control system, embedded computing device, or other electronic device.

System 1000 represents a computer system that includes microchannel structure 1090, which can represent a microchannel structure in accordance with any example described. Microchannel structure 1090 can include open microchannels or microchannels that are sealed during integrated processing. Microchannel structure 1090 can include microchannels with rectangular, square, triangular, or trapezoidal cross sections. Microchannel structure 1090 can include a 2D patterning to allow fluid to flow under a hot spot and transfer the heat through the system packaging. In one example, processor 1010 includes microchannel structure 1090 under or as part of its packaging. Microchannel structure 1090 could be part of graphics 1040, storage subsystem 1080, memory subsystem 1020, or other components in system 1000.

System 1000 includes processor 1010 can include any type of microprocessor, central processing unit (CPU), graphics processing unit (GPU), processing core, or other processing hardware, or a combination, to provide processing or execution of instructions for system 1000. Processor 1010 can be a host processor device. Processor 1010 controls the overall operation of system 1000, and can be or include, one or more programmable general-purpose or special-purpose microprocessors, digital signal processors (DSPs), programmable controllers, application specific integrated circuits (ASICs), programmable logic devices (PLDs), or a combination of such devices.

System 1000 includes boot/config 1016, which represents storage to store boot code (e.g., basic input/output system (BIOS)), configuration settings, security hardware (e.g., trusted platform module (TPM)), or other system level hardware that operates outside of a host OS. Boot/config 1016 can include a nonvolatile storage device, such as read-only memory (ROM), flash memory, or other memory devices.

In one example, system 1000 includes interface 1012 coupled to processor 1010, which can represent a higher speed interface or a high throughput interface for system components that need higher bandwidth connections, such as memory subsystem 1020 or graphics interface components 1040. Interface 1012 represents an interface circuit, which can be a standalone component or integrated onto a processor die. Interface 1012 can be integrated as a circuit onto the processor die or integrated as a component on a system on a chip. Where present, graphics interface 1040 interfaces to graphics components for providing a visual display to a user of system 1000. Graphics interface 1040 can be a standalone component or integrated onto the processor die or system on a chip. In one example, graphics interface 1040 can drive a high definition (HD) display or ultra high definition (UHD) display that provides an output to a user. In one example, the display can include a touchscreen display. In one example, graphics interface 1040 generates a display based on data stored in memory 1030 or based on operations executed by processor 1010 or both.

Memory subsystem 1020 represents the main memory of system 1000, and provides storage for code to be executed by processor 1010, or data values to be used in executing a routine. Memory subsystem 1020 can include one or more varieties of random-access memory (RAM) such as DRAM, 3DXP (three-dimensional crosspoint), or other memory devices, or a combination of such devices. Memory 1030 stores and hosts, among other things, operating system (OS) 1032 to provide a software platform for execution of instructions in system 1000. Additionally, applications 1034 can execute on the software platform of OS 1032 from memory 1030. Applications 1034 represent programs that have their own operational logic to perform execution of one or more functions. Processes 1036 represent agents or routines that provide auxiliary functions to OS 1032 or one or more applications 1034 or a combination. OS 1032, applications 1034, and processes 1036 provide software logic to provide functions for system 1000. In one example, memory subsystem 1020 includes memory controller 1022, which is a memory controller to generate and issue commands to memory 1030. It will be understood that memory controller 1022 could be a physical part of processor 1010 or a physical part of interface 1012. For example, memory controller 1022 can be an integrated memory controller, integrated onto a circuit with processor 1010, such as integrated onto the processor die or a system on a chip.

While not specifically illustrated, it will be understood that system 1000 can include one or more buses or bus systems between devices, such as a memory bus, a graphics bus, interface buses, or others. Buses or other signal lines can communicatively or electrically couple components together, or both communicatively and electrically couple the components. Buses can include physical communication lines, point-to-point connections, bridges, adapters, controllers, or other circuitry or a combination. Buses can include, for example, one or more of a system bus, a Peripheral Component Interconnect (PCI) bus, a HyperTransport or industry standard architecture (ISA) bus, a small computer system interface (SCSI) bus, a universal serial bus (USB), or other bus, or a combination.

In one example, system 1000 includes interface 1014, which can be coupled to interface 1012. Interface 1014 can be a lower speed interface than interface 1012. In one example, interface 1014 represents an interface circuit, which can include standalone components and integrated circuitry. In one example, multiple user interface components or peripheral components, or both, couple to interface 1014. Network interface 1050 provides system 1000 the ability to communicate with remote devices (e.g., servers or other computing devices) over one or more networks. Network interface 1050 can include an Ethernet adapter, wireless interconnection components, cellular network interconnection components, USB (universal serial bus), or other wired or wireless standards-based or proprietary interfaces. Network interface 1050 can exchange data with a remote device, which can include sending data stored in memory or receiving data to be stored in memory.

In one example, system 1000 includes one or more input/output (I/O) interface(s) 1060. I/O interface 1060 can include one or more interface components through which a user interacts with system 1000 (e.g., audio, alphanumeric, tactile/touch, or other interfacing). Peripheral interface 1070 can include any hardware interface not specifically mentioned above. Peripherals refer generally to devices that connect dependently to system 1000. A dependent connection is one where system 1000 provides the software platform or hardware platform or both on which operation executes, and with which a user interacts.

In one example, system 1000 includes storage subsystem 1080 to store data in a nonvolatile manner. In one example, in certain system implementations, at least certain components of storage 1080 can overlap with components of memory subsystem 1020. Storage subsystem 1080 includes storage device(s) 1084, which can be or include any conventional medium for storing large amounts of data in a nonvolatile manner, such as one or more magnetic, solid state, NAND, 3DXP, or optical based disks, or a combination. Storage 1084 holds code or instructions and data 1086 in a persistent state (i.e., the value is retained despite interruption of power to system 1000). Storage 1084 can be generically considered to be a "memory," although memory 1030 is typically the executing or operating memory to provide instructions to processor 1010. Whereas storage 1084 is nonvolatile, memory 1030 can include volatile memory (i.e., the value or state of the data is indeterminate if power is interrupted to system 1000). In one example, storage subsystem 1080 includes controller 1082 to interface with storage 1084. In one example controller 1082 is a physical part of interface 1014 or processor 1010, or can include circuits or logic in both processor 1010 and interface 1014.

Power source 1002 provides power to the components of system 1000. More specifically, power source 1002 typically interfaces to one or multiple power supplies 1004 in system 1000 to provide power to the components of system 1000. In one example, power supply 1004 includes an AC to DC (alternating current to direct current) adapter to plug into a wall outlet. Such AC power can be renewable energy (e.g., solar power) power source 1002. In one example, power source 1002 includes a DC power source, such as an external AC to DC converter. In one example, power source 1002 or power supply 1004 includes wireless charging hardware to charge via proximity to a charging field. In one example, power source 1002 can include an internal battery or fuel cell source.

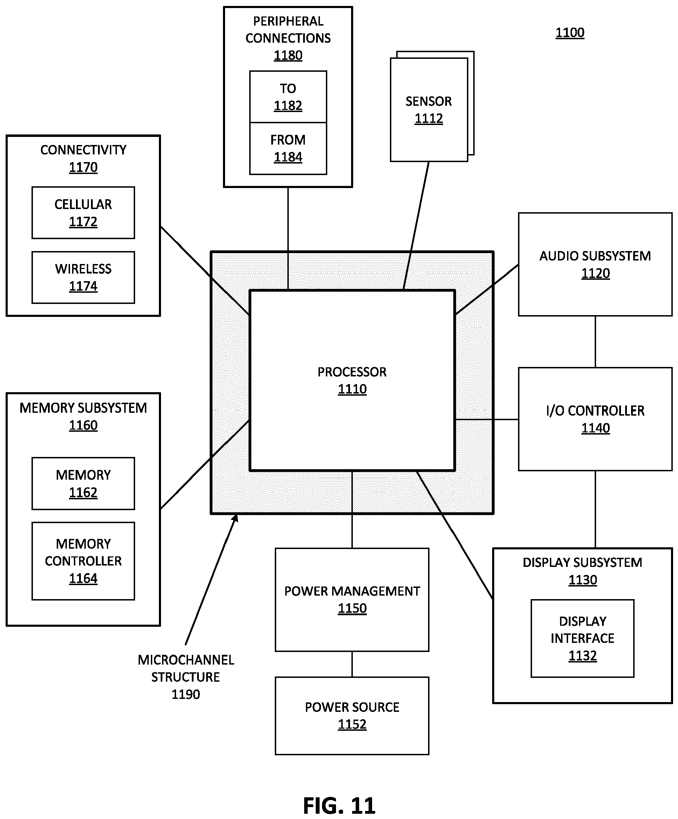

**Figure 11** is a block diagram of an example of a mobile device in which an integrated microchannel heat spreader can be implemented. System 1100 represents a mobile computing device, such as a computing tablet, a mobile phone or smartphone, wearable computing device, or other mobile device, or an embedded computing device. It will be understood that certain of the components are shown generally, and not all components of such a device are shown in system 1100.

System 1100 represents a computer system that includes microchannel structure 1190, which can represent a microchannel structure in accordance with any example described. Microchannel structure 1190 can include open microchannels or microchannels that are sealed during integrated processing. Microchannel structure 1190 can include microchannels with rectangular, square, triangular, or trapezoidal cross sections. Microchannel structure 1190 can include a 2D patterning to allow fluid to flow under a hot spot and transfer the heat through the system packaging. In one example, processor 1110 includes microchannel structure 1190 under or as part of its packaging. Microchannel structure 1190 could be part of display subsystem 1130, memory subsystem 1160, or other components in system 1100.

System 1100 includes processor 1110, which performs the primary processing operations of system 1100. Processor 1110 can be a host processor device. Processor 1110 can include one or more physical devices, such as microprocessors, application processors, microcontrollers, programmable logic devices, or other processing means. The processing operations performed by processor 1110 include the execution of an operating platform or operating system on which applications and device functions are executed. The processing operations include operations related to I/O (input/output) with a human user or with other devices, operations related to power management, operations related to connecting system 1100 to another device, or a combination. The processing operations can also include operations related to audio I/O, display I/O, or other interfacing, or a combination. Processor 1110 can execute data stored in memory. Processor 1110 can write or edit data stored in memory.

In one example, system 1100 includes one or more sensors 1112. Sensors 1112 represent embedded sensors or interfaces to external sensors, or a combination. Sensors 1112 enable system 1100 to monitor or detect one or more conditions of an environment or a device in which system 1100 is implemented. Sensors 1112 can include environmental sensors (such as temperature sensors, motion detectors, light detectors, cameras, chemical sensors (e.g., carbon monoxide, carbon dioxide, or other chemical sensors)), pressure sensors, accelerometers, gyroscopes, medical or physiology sensors (e.g., biosensors, heart rate monitors, or other sensors to detect physiological attributes), or other sensors, or a combination. Sensors 1112 can also include sensors for biometric systems such as fingerprint recognition systems, face detection or recognition systems, or other systems that detect or recognize user features. Sensors 1112 should be understood broadly, and not limiting on the many different types of sensors that could be implemented with system 1100. In one example, one or more sensors 1112 couples to processor 1110 via a frontend circuit integrated with processor 1110. In one example, one or more sensors 1112 couples to processor 1110 via another component of system 1100.

In one example, system 1100 includes audio subsystem 1120, which represents hardware (e.g., audio hardware and audio circuits) and software (e.g., drivers, codecs) components associated with providing audio functions to the computing device. Audio functions can include speaker or headphone output, as well as microphone input. Devices for such functions can be integrated into system 1100, or connected to system 1100. In one example, a user interacts with system 1100 by providing audio commands that are received and processed by processor 1110.

Display subsystem 1130 represents hardware (e.g., display devices) and software components (e.g., drivers) that provide a visual display for presentation to a user. In one example, the display includes tactile components or touchscreen elements for a user to interact with the computing device. Display subsystem 1130 includes display interface 1132, which includes the particular screen or hardware device used to provide a display to a user. In one example, display interface 1132 includes logic separate from processor 1110 (such as a graphics processor) to perform at least some processing related to the display. In one example, display subsystem 1130 includes a touchscreen device that provides both output and input to a user. In one example, display subsystem 1130 includes a high definition (HD) or ultra-high definition (UHD) display that provides an output to a user. In one example, display subsystem includes or drives a touchscreen display. In one example, display subsystem 1130 generates display information based on data stored in memory or based on operations executed by processor 1110 or both.

I/O controller 1140 represents hardware devices and software components related to interaction with a user. I/O controller 1140 can operate to manage hardware that is part of audio subsystem 1120, or display subsystem 1130, or both. Additionally, I/O controller 1140 illustrates a connection point for additional devices that connect to system 1100 through which a user might interact with the system. For example, devices that can be attached to system 1100 might include microphone devices, speaker or stereo systems, video systems or other display device, keyboard or keypad devices, buttons/switches, or other I/O devices for use with specific applications such as card readers or other devices.

As mentioned above, I/O controller 1140 can interact with audio subsystem 1120 or display subsystem 1130 or both. For example, input through a microphone or other audio device can provide input or commands for one or more applications or functions of system 1100. Additionally, audio output can be provided instead of or in addition to display output. In another example, if display subsystem includes a touchscreen, the display device also acts as an input device, which can be at least partially managed by I/O controller 1140. There can also be additional buttons or switches on system 1100 to provide I/O functions managed by I/O controller 1140.

In one example, I/O controller 1140 manages devices such as accelerometers, cameras, light sensors or other environmental sensors, gyroscopes, global positioning system (GPS), or other hardware that can be included in system 1100, or sensors 1112. The input can be part of direct user interaction, as well as providing environmental input to the system to influence its operations (such as filtering for noise, adjusting displays for brightness detection, applying a flash for a camera, or other features).

In one example, system 1100 includes power management 1150 that manages battery power usage, charging of the battery, and features related to power saving operation. Power management 1150 manages power from power source 1152, which provides power to the components of system 1100. In one example, power source 1152 includes an AC to DC (alternating current to direct current) adapter to plug into a wall outlet. Such AC power can be renewable energy (e.g., solar power, motion based power). In one example, power source 1152 includes only DC power, which can be provided by a DC power source, such as an external AC to DC converter. In one example, power source 1152 includes wireless charging hardware to charge via proximity to a charging field. In one example, power source 1152 can include an internal battery or fuel cell source.

Memory subsystem 1160 includes memory device(s) 1162 for storing information in system 1100. Memory subsystem 1160 can include nonvolatile (state does not change if power to the memory device is interrupted) or volatile (state is indeterminate if power to the memory device is interrupted) memory devices, or a combination. Memory 1160 can store application data, user data, music, photos, documents, or other data, as well as system data (whether long-term or temporary) related to the execution of the applications and functions of system 1100. In one example, memory subsystem 1160 includes memory controller 1164 (which could also be considered part of the control of system 1100, and could potentially be considered part of processor 1110). Memory controller 1164 includes a scheduler to generate and issue commands to control access to memory device 1162.

Connectivity 1170 includes hardware devices (e.g., wireless or wired connectors and communication hardware, or a combination of wired and wireless hardware) and software components (e.g., drivers, protocol stacks) to enable system 1100 to communicate with external devices. The external device could be separate devices, such as other computing devices, wireless access points or base stations, as well as peripherals such as headsets, printers, or other devices. In one example, system 1100 exchanges data with an external device for storage in memory or for display on a display device. The exchanged data can include data to be stored in memory, or data already stored in memory, to read, write, or edit data.

Connectivity 1170 can include multiple different types of connectivity. To generalize, system 1100 is illustrated with cellular connectivity 1172 and wireless connectivity 1174. Cellular connectivity 1172 refers generally to cellular network connectivity provided by wireless carriers, such as provided via GSM (global system for mobile communications) or variations or derivatives, CDMA (code division multiple access) or variations or derivatives, TDM (time division multiplexing) or variations or derivatives, LTE (long term evolution - also referred to as "4G"), 5G, or other cellular service standards. Wireless connectivity 1174 refers to wireless connectivity that is not cellular, and can include personal area networks (such as Bluetooth), local area networks (such as WiFi), or wide area networks (such as WiMax), or other wireless communication, or a combination. Wireless communication refers to transfer of data through the use of modulated electromagnetic radiation through a non-solid medium. Wired communication occurs through a solid communication medium.

Peripheral connections 1180 include hardware interfaces and connectors, as well as software components (e.g., drivers, protocol stacks) to make peripheral connections. It will be understood that system 1100 could both be a peripheral device ("to" 1182) to other computing devices, as well as have peripheral devices ("from" 1184) connected to it. System 1100 commonly has a "docking" connector to connect to other computing devices for purposes such as managing (e.g., downloading, uploading, changing, synchronizing) content on system 1100. Additionally, a docking connector can allow system 1100 to connect to certain peripherals that allow system 1100 to control content output, for example, to audiovisual or other systems.

In addition to a proprietary docking connector or other proprietary connection hardware, system 1100 can make peripheral connections 1180 via common or standards-based connectors. Common types can include a Universal Serial Bus (USB) connector (which can include any of a number of different hardware interfaces), DisplayPort including MiniDisplayPort (MDP), High Definition Multimedia Interface (HDMI), or other type.

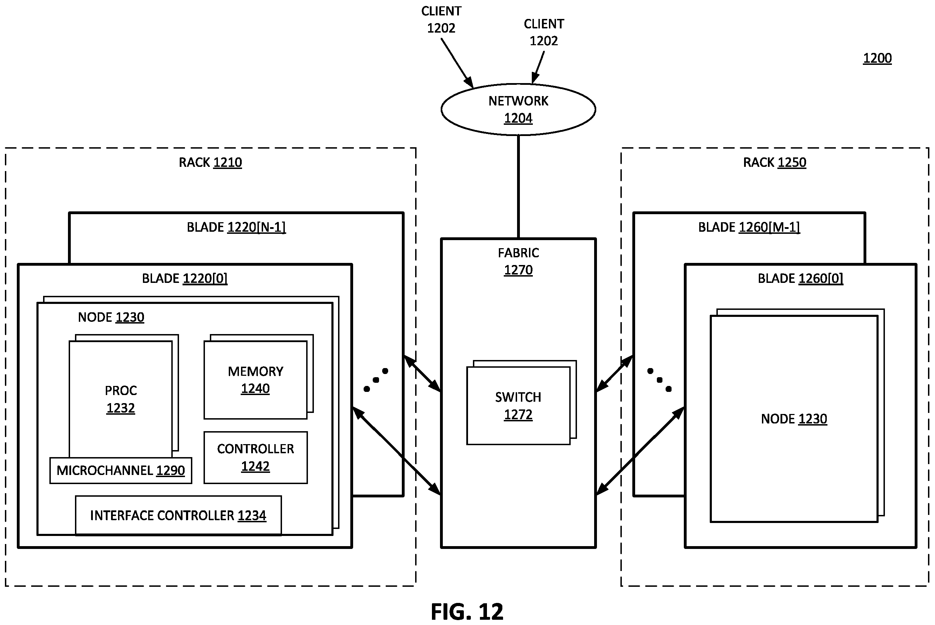

**Figure 12** is a block diagram of an example of a multi-node network in which an integrated microchannel heat spreader can be implemented. System 1200 represents a network of nodes that can apply adaptive ECC. In one example, system 1200 represents a data center. In one example, system 1200 represents a server farm. In one example, system 1200 represents a data cloud or a processing cloud.

System 1200 includes node 1230, which represents a computer system that includes microchannel structure 1290, which can represent a microchannel structure in accordance with any example described. Microchannel structure 1290 can include open microchannels or microchannels that are sealed during integrated processing. Microchannel structure 1290 can include microchannels with rectangular, square, triangular, or trapezoidal cross sections. Microchannel structure 1290 can include a 2D patterning to allow fluid to flow under a hot spot and transfer the heat through the system packaging. In one example, processor 1232 includes microchannel structure 1290 under or as part of its packaging. While microchannel structure 1290 is illustrated as being associated with processor 1232, the microchannel structure could be part of graphics, storage subsystem, memory, or other components in node 1230.

One or more clients 1202 make requests over network 1204 to system 1200. Network 1204 represents one or more local networks, or wide area networks, or a combination. Clients 1202 can be human or machine clients, which generate requests for the execution of operations by system 1200. System 1200 executes applications or data computation tasks requested by clients 1202.

In one example, system 1200 includes one or more racks, which represent structural and interconnect resources to house and interconnect multiple computation nodes. In one example, rack 1210 includes multiple nodes 1230. In one example, rack 1210 hosts multiple blade components 1220. Hosting refers to providing power, structural or mechanical support, and interconnection. Blades 1220 can refer to computing resources on printed circuit boards (PCBs), where a PCB houses the hardware components for one or more nodes 1230. In one example, blades 1220 do not include a chassis or housing or other "box" other than that provided by rack 1210. In one example, blades 1220 include housing with exposed connector to connect into rack 1210. In one example, system 1200 does not include rack 1210, and each blade 1220 includes a chassis or housing that can stack or otherwise reside in close proximity to other blades and allow interconnection of nodes 1230.

System 1200 includes fabric 1270, which represents one or more interconnectors for nodes 1230. In one example, fabric 1270 includes multiple switches 1272 or routers or other hardware to route signals among nodes 1230. Additionally, fabric 1270 can couple system 1200 to network 1204 for access by clients 1202. In addition to routing equipment, fabric 1270 can be considered to include the cables or ports or other hardware equipment to couple nodes 1230 together. In one example, fabric 1270 has one or more associated protocols to manage the routing of signals through system 1200. In one example, the protocol or protocols is at least partly dependent on the hardware equipment used in system 1200.

As illustrated, rack 1210 includes N blades 1220. In one example, in addition to rack 1210, system 1200 includes rack 1250. As illustrated, rack 1250 includes M blades 1260. M is not necessarily the same as N; thus, it will be understood that various different hardware equipment components could be used, and coupled together into system 1200 over fabric 1270. Blades 1260 can be the same or similar to blades 1220. Nodes 1230 can be any type of node and are not necessarily all the same type of node. System 1200 is not limited to being homogenous, nor is it limited to not being homogenous.

For simplicity, only the node in blade 1220[0] is illustrated in detail. However, other nodes in system 1200 can be the same or similar. At least some nodes 1230 are computation nodes, with processor (proc) 1232 and memory 1240. Memory 1240 represents memory (whether volatile or nonvolatile) resources in node 1230. Controller 1242 manages access to memory 1240. A computation node refers to a node with processing resources (e.g., one or more processors) that executes an operating system and can receive and process one or more tasks. In one example, at least some nodes 1230 are server nodes with a server as processing resources represented by processor 1232 and memory 1240. A storage server refers to a node with more storage resources than a computation node, and rather than having processors for the execution of tasks, a storage server includes processing resources to manage access to the storage nodes within the storage server.

In one example, node 1230 includes interface controller 1234, which represents logic to control access by node 1230 to fabric 1270. The logic can include hardware resources to interconnect to the physical interconnection hardware. The logic can include software or firmware logic to manage the interconnection. In one example, interface controller 1234 is or includes a host fabric interface, which can be a fabric interface in accordance with any example described herein.

Processor 1232 can include one or more separate processors. Each separate processor can include a single processing unit, a multicore processing unit, or a combination. The processing unit can be a primary processor such as a CPU (central processing unit), a peripheral processor such as a GPU (graphics processing unit), or a combination.

In general with respect to the descriptions herein, in one example an electronic assembly includes: an electronic die in a package; a microchannel integrated onto a package layer to spread heat localized in the package at the electronic die, the microchannel having a hollow heat conducting material with a rectangular cross-section through which a fluid is to flow to spread the heat.

In one example of the electronic assembly, the package layer comprises an integrated heat spreader mounted over the electronic die. In accordance with any preceding example of the electronic assembly, in one example, the package layer comprises a substrate on which the electronic die is mounted. In accordance with any preceding example of the electronic assembly, in one example, the microchannel comprises a first microchannel and the package layer comprises an integrated heat spreader mounted over the electronic die, and further including: a second microchannel integrated onto a substrate on which the electronic die is mounted. In accordance with any preceding example of the electronic assembly, in one example, the package layer comprises an interposer layer of a 3D (three dimensional) multi-die stack. In accordance with any preceding example of the electronic assembly, in one example, the microchannel comprises an open microchannel, wherein a pump is to pump the fluid through the microchannel. In accordance with any preceding example of the electronic assembly, in one example, the microchannel comprises a closed heat pipe, wherein the fluid is to diffuse through the microchannel in response to the heat localized in the package at the electronic die. In accordance with any preceding example of the electronic assembly, in one example, the fluid comprises de-ionized water. In accordance with any preceding example of the electronic assembly, in one example, the heat conducting material comprises copper.

In general with respect to the descriptions herein, in one example a computer system includes: a processor on a substrate; and a microchannel integrated onto a package layer to spread heat localized at the processor, the microchannel having a hollow heat conducting material with a rectangular cross-section through which a fluid is to flow to spread the heat.

In one example of the computer system, the package layer comprises an integrated heat spreader mounted over the processor. In accordance with any preceding example of the computer system, in one example, the package layer comprises the substrate. In accordance with any preceding example of the computer system, in one example, the microchannel comprises an open microchannel, wherein a pump is to pump the fluid through the microchannel. In accordance with any preceding example of the computer system, in one example, the microchannel comprises a closed heat pipe, wherein the fluid is to diffuse through the microchannel in response to the heat localized in the package at the processor. In accordance with any preceding example of the computer system, in one example, the fluid comprises de-ionized water. In accordance with any preceding example of the computer system, in one example, the processor comprises a central processing unit. In accordance with any preceding example of the computer system, in one example, the processor comprises a field programmable gate array (FPGA).

In general with respect to the descriptions herein, in one example a method includes: depositing a metal on a substrate; forming a microchannel having a rectangular cross section; filling the microchannel with fluid; and sealing the microchannel.

In one example of the method, forming the microchannel comprises: depositing a thermal decomposable material (TDM) in the microchannel; depositing the metal over the TDM to form the microchannel with the rectangular cross section; and removing the TDM from the microchannel. In accordance with any preceding example of the method, in one example, sealing the microchannel comprises connecting a pump to an open microchannel, wherein the pump is to pump the fluid through the microchannel. In accordance with any preceding example of the method, in one example, sealing the microchannel comprises forming a hermetic seal of the microchannel filled with liquid, to form a closed microchannel through which the liquid is to diffuse.

In general with respect to the descriptions herein, in one example an electronic assembly includes: an electronic die in a package; a microchannel integrated onto a package layer to spread heat localized in the package at the electronic die, the microchannel having a hollow heat conducting material through which a fluid is to flow to spread the heat, the microchannel having sides that meet at an acute angle, the microchannel having a dielectric seal capped by the heat conducting material.

In one example of the electronic assembly, the package layer comprises an integrated heat spreader mounted over the electronic die. In accordance with any preceding example of the electronic assembly, in one example, the package layer comprises a substrate on which the electronic die is disposed. In accordance with any preceding example of the electronic assembly, in one example, microchannel comprises a first microchannel and the package layer comprises an integrated heat spreader mounted over the electronic die, and further including: a second microchannel integrated onto a substrate on which the electronic die is disposed. In accordance with any preceding example of the electronic assembly, in one example, the package layer comprises an interposer layer of a 3D (three dimensional) multi-die stack. In accordance with any preceding example of the electronic assembly, in one example, the dielectric seal comprises a hermetic seal capped by metal. In accordance with any preceding example of the electronic assembly, in one example, the fluid comprises de-ionized water. In accordance with any preceding example of the electronic assembly, in one example, the heat conducting material comprises copper.

In general with respect to the descriptions herein, in one example a computer system includes: a processor on a substrate; and a microchannel integrated onto a package layer to spread heat localized in the package at the electronic die, the microchannel having a hollow heat conducting material through which a fluid is to flow to spread the heat, the microchannel having sides that meet at an acute angle, the microchannel having a dielectric seal capped by the heat conducting material.

In one example of the computer system, the package layer comprises an integrated heat spreader mounted over the processor. In accordance with any preceding example of the computer system, in one example, the package layer comprises the substrate. In accordance with any preceding example of the computer system, in one example, the package layer comprises an interposer layer of a 3D (three dimensional) multi-die stack. In accordance with any preceding example of the computer system, in one example, the dielectric seal comprises a hermetic seal capped by metal. In accordance with any preceding example of the computer system, in one example, the fluid comprises de-ionized water. In accordance with any preceding example of the computer system, in one example, the processor comprises a central processing unit. In accordance with any preceding example of the computer system, in one example, the processor comprises a field programmable gate array (FPGA).

In general with respect to the descriptions herein, in one example a method includes: depositing a metal on a substrate; forming a microchannel having sides that meet at an acute angle; filling the microchannel with liquid; and forming a seal to close the microchannel.

In one example of the method, forming the microchannel comprises: depositing a thermal decomposable material (TDM) a metal layer; exposing the TDM with an optical heat source via a prism to form openings in the TDM at an angle with respect to a surface of the metal layer; and filling the openings with metal to form the microchannel with a triangular cross section or a trapezoidal cross section. In accordance with any preceding example of the method, in one example, forming the microchannel comprises: removing the TDM from the microchannel. In accordance with any preceding example of the method, in one example, sealing the microchannel comprises forming a hermetic seal of the microchannel filled with liquid, to form a closed microchannel through which the liquid is to diffuse.

Flow diagrams as illustrated herein provide examples of sequences of various process actions. The flow diagrams can indicate operations to be executed by a software or firmware routine, as well as physical operations. A flow diagram can illustrate an example of the implementation of states of a finite state machine (FSM), which can be implemented in hardware and/or software. Although shown in a particular sequence or order, unless otherwise specified, the order of the actions can be modified. Thus, the illustrated diagrams should be understood only as examples, and the process can be performed in a different order, and some actions can be performed in parallel. Additionally, one or more actions can be omitted; thus, not all implementations will perform all actions.

To the extent various operations or functions are described herein, they can be described or defined as software code, instructions, configuration, and/or data. The content can be directly executable ("object" or "executable" form), source code, or difference code ("delta" or "patch" code). The software content of what is described herein can be provided via an article of manufacture with the content stored thereon, or via a method of operating a communication interface to send data via the communication interface. A machine readable storage medium can cause a machine to perform the functions or operations described, and includes any mechanism that stores information in a form accessible by a machine (e.g., computing device, electronic system, etc.), such as recordable/non-recordable media (e.g., read only memory (ROM), random access memory (RAM), magnetic disk storage media, optical storage media, flash memory devices, etc.). A communication interface includes any mechanism that interfaces to any of a hardwired, wireless, optical, etc., medium to communicate to another device, such as a memory bus interface, a processor bus interface, an Internet connection, a disk controller, etc. The communication interface can be configured by providing configuration parameters and/or sending signals to prepare the communication interface to provide a data signal describing the software content. The communication interface can be accessed via one or more commands or signals sent to the communication interface.

Various components described herein can be a means for performing the operations or functions described. Each component described herein includes software, hardware, or a combination of these. The components can be implemented as software modules, hardware modules, special-purpose hardware (e.g., application specific hardware, application specific integrated circuits (ASICs), digital signal processors (DSPs), etc.), embedded controllers, hardwired circuitry, etc.

Besides what is described herein, various modifications can be made to what is disclosed and implementations of the invention without departing from their scope. Therefore, the illustrations and examples herein should be construed in an illustrative, and not a restrictive sense. The scope of the invention should be measured solely by reference to the claims that follow.

## Claims

1. A system for heat spreading, comprising:
an electronic die in a package;
a microchannel integrated onto a package layer to spread heat localized in the package at the electronic die, the microchannel having a hollow heat conducting material with a rectangular cross-section through which a fluid is to flow to spread the heat.

2. The system of claim 1, wherein the package layer comprises an integrated heat spreader mounted over the electronic die.

3. The system of either of claims 1 or 2, wherein the package layer comprises a substrate on which the electronic die is mounted.

4. The system of claim 3, wherein the microchannel comprises a first microchannel and the package layer comprises an integrated heat spreader mounted over the electronic die, and further comprising:
a second microchannel integrated onto a substrate on which the electronic die is mounted.

5. The system of either of claims 1 or 2, wherein the package layer comprises an interposer layer of a 3D (three dimensional) multi-die stack.

6. The system of any of claims 1 to 5, wherein the microchannel comprises an open microchannel, wherein a pump is to pump the fluid through the microchannel.

7. The system of any of claims 1 to 5, wherein the microchannel comprises a closed heat pipe, wherein the fluid is to diffuse through the microchannel in response to the heat localized in the package at the electronic die.

8. The system of any of claims 1 to 7, wherein the fluid comprises de-ionized water.

9. The system of any of claims 1 to 8, wherein the heat conducting material comprises copper.

10. The system of any of claims 1 to 9, comprising:
a processor on a substrate;
wherein the package is mounted on the substrate.

11. The system of any of claims 1 to 10, wherein the processor comprises a central processing unit.

12. The system of any of claims 1 to 10, wherein the processor comprises a field programmable gate array (FPGA).
